# EUROPEAN PATENT APPLICATION

(11) **EP 4 528 808 A1**
(43) Date of publication of application: **26.03.2025**
(21) Application number: 23878972.1
(22) Date of filing: 08.10.2023
(51) Int. Cl.: H01L 23/488, H02M 7/217, H02M 3/335, H02M 1/088

(54) **CHIP, CONTROL CHIP, SWITCHING POWER SUPPLY AND POWER ADAPTER**

(30) Priority: 20.10.2022 CN 202211289644
(71) Applicant: Huawei Technologies Co., Ltd., Shenzhen, Guangdong 518129 (CN)
(72) Inventor: ZHANG, Dongliang, Shenzhen, Guangdong 518129 (CN); HOU, Qinghui, Shenzhen, Guangdong 518129 (CN)
(74) Representative: Körber, Martin Hans
(86) International application number: PCT/CN2023/123416
(87) International publication number: WO 2024/082980

(57) **Abstract**

This application provides a chip, a control chip, a switching power supply, and a power adapter, and relates to the field of electronic technologies, which can ensure current detection precision. The chip includes: a substrate; a first switching transistor fabricated on the substrate; and a second switching transistor and a third switching transistor that are fabricated on the substrate, where the second switching transistor is disposed in a first region on the substrate, and the third switching transistor is disposed in a second region on the substrate.

## Description

This application claims priority to Chinese Patent Application No. 202211289644.8, filed with the China National Intellectual Property Administration on October 20, 2022 and entitled "CHIP, CONTROL CHIP, SWITCHING POWER SUPPLY, AND POWER ADAPTER", which is incorporated herein by reference in its entirety.

### TECHNICAL FIELD

Embodiments of this application relate to the field of electronic technologies, and in particular, to a chip, a control chip, a switching power supply, and a power adapter.

### BACKGROUND

Switching power supplies are widely used in power adapters (or chargers) of electronic devices such as mobile phones, watches, and tablet computers. Switching power supplies with a power lower than 400 W account for about 70% to 80% of the market. Flyback switching power supplies account for a large proportion because of simple circuit structures and low costs. Almost all common consumer power supply products such as mobile phone chargers and notebook computer chargers use the flyback switching power supplies.

Overcurrent protection needs to be performed on a circuit to ensure normal working of the switching power supply and prevent performance deterioration or even burning of a circuit component caused by overcurrent or the like. Therefore, how to further improve precision of detecting a current flowing through a primary side of the switching power supply is of great significance.

### SUMMARY

Embodiments of this application provide a chip, a control chip, a switching power supply, and a power adapter, to improve current detection precision.

According to a first aspect, a chip is provided. The chip includes: a substrate; a first switching transistor fabricated on the substrate; and a second switching transistor and a third switching transistor that are fabricated on the substrate. The second switching transistor is disposed in a first region on the substrate, and the third switching transistor is disposed in a second region on the substrate. A drain of the first switching transistor is connected to a first pad, a source of the first switching transistor is connected to a second pad, and a gate of the first switching transistor is connected to a third pad. The first pad is configured to connect to a high-potential end, the second pad is configured to connect to a low-potential end, and the third pad is configured to connect to a control integrated circuit. A drain of the second switching transistor and a drain of the third switching transistor are connected to a fourth pad, and a source of the second switching transistor and a source of the third switching transistor are connected to a fifth pad; or the drain of the second switching transistor is connected to the fourth pad, the drain of the third switching transistor is connected to the source of the second switching transistor, and the source of the third switching transistor is connected to the fifth pad. A gate of the second switching transistor and a gate of the third switching transistor are connected to a sixth pad. The fourth pad is configured to connect to the high-potential end, the fifth pad is configured to connect to a sampling resistor, and the sixth pad is configured to connect to the control integrated circuit.

On the chip, the drain of the first switching transistor is connected to the first pad, the source of the first switching transistor is connected to the second pad, and the gate of the first switching transistor is connected to the third pad. The first pad is configured to connect to the high-potential end, the second pad is configured to connect to the low-potential end, and the third pad is configured to connect to the control integrated circuit. In this way, a turn-on state of the first switching transistor is controlled by using the control integrated circuit to form a power current loop between the high-potential end and the low-potential end. The second switching transistor and the third switching transistor are respectively fabricated in different regions on the substrate on which the first switching transistor is located. In addition, after the second switching transistor and the third switching transistor are connected in series or in parallel, the fourth pad is connected to the high-potential end, and the fifth pad is connected to the sampling circuit. Moreover, the gate of the second switching transistor and the gate of the third switching transistor are connected to the sixth pad, and the sixth pad is connected to the control integrated circuit. Therefore, turn-on states of the third switching transistor and the second switching transistor are controlled by using the control integrated circuit to form a current sampling link. In this way, the second switching transistor and the third switching transistor serve as equivalent switching transistors on the current sampling link, so that impact of a difference between material defects at different locations on a chip yield may be avoided, thereby reducing impact of fluctuation of a turn-on resistance (or a dynamic turn-on resistance) of a switching transistor on current sampling precision. Specifically, when the second switching transistor and the third switching transistor are connected in parallel, if a turn-on resistance of the second switching transistor in the first region increases due to a material defect, and a turn-on resistance of the third switching transistor in the second region decreases due to a material defect, equivalent resistances of the second switching transistor and the third switching transistor connected in parallel may reduce the fluctuation of the turn-on resistance (or the dynamic turn-on resistance), thereby reducing impact on current sampling precision. For another example, when the second switching transistor and the third switching transistor are connected in series, and equivalent resistances are consistent, a resistance value of a single device connected in series needs to be further reduced. Therefore, a gate width of the second switching transistor and a gate width of the third switching transistor may be increased as much as possible, to reduce the equivalent resistance. After the gate width is increased, the switching transistor occupies a larger chip area on the substrate. Therefore, this can effectively avoid impact of a local material defect on fluctuation of the turn-on resistance (or the dynamic turn-on resistance), thereby reducing impact on current sampling precision.

In a possible implementation, the substrate includes a first equal partition region and a second equal partition region, the first region is the first equal partition region, and the second region is the second equal partition region. The second switching transistor and the third switching transistor are fabricated at an epitaxial layer on the substrate. Therefore, the turn-on impedances of the second switching transistor and the third switching transistor depend on material characteristic parameters of the epitaxial layer. However, material characteristic parameters of the epitaxial layer at different locations on the substrate are randomly distributed. For ensuring that equivalent impedances of the second switching transistor and the third switching transistor or more switching transistors connected in series or in parallel can effectively avoid impact of the local material defect on fluctuation of the turn-on resistance (or the dynamic turn-on resistance), the substrate may be equally partitioned into a plurality of equally partitioned regions, and switching transistors used for the current sampling link are evenly distributed in the equal partition regions.

In a possible implementation, the second switching transistor and the third switching transistor are fabricated at an epitaxial layer on the substrate, and both a material characteristic parameter of the epitaxial layer in the first region and a material characteristic parameter of the epitaxial layer in the second region fall within a predetermined range. Because the second switching transistor and the third switching transistor are fabricated at the epitaxial layer on the substrate, the turn-on impedances of the second switching transistor and the third switching transistor depend on material characteristic parameters of the epitaxial layer. However, material characteristic parameters of the epitaxial layer at different locations on the substrate are randomly distributed. Therefore, for ensuring that equivalent impedances of the second switching transistor and the third switching transistor or more switching transistors connected in series or in parallel can effectively avoid impact of the local material defect on fluctuation of the turn-on resistance (or the dynamic turn-on resistance), the second switching transistor and the third switching transistor may be separately fabricated in regions in which the material characteristic parameters are close as much as possible. For example, the material characteristic parameter may be measured by a defect density per unit area. The defect may be a material defect at the epitaxial layer or a defect caused by a fabricating process on a device.

In a possible implementation, a ratio of an average impedance of the second switching transistor and the third switching transistor to an impedance of the first switching transistor ranges from 10:1 to 1000: 1. A current sampling range is guaranteed when a chip area is not affected. In addition, an impedance ratio cannot be excessively large, to ensure that areas occupied by the second switching transistor and the third switching transistor on the substrate are not excessively small, and ensure current sampling precision.

In a possible implementation, the first switching transistor, the second switching transistor, and the third switching transistor have a consistent cell structure, and the second switching transistor and the third switching transistor occupy a same area on the substrate. When the second switching transistor and the third switching transistor have the same cell structure and occupy the same area, impedance uniformity is relatively high, further improving current sampling precision.

In a possible implementation, the chip further includes a fourth switching transistor. The fourth switching transistor is disposed in a third region on the substrate, a drain of the fourth switching transistor is connected to a seventh pad, a source of the fourth switching transistor is connected to an eighth pad, and a gate of the fourth switching transistor is connected to a ninth pad. The seventh pad is configured to connect to the high-potential end. The eighth pad is configured to connect to the sampling circuit, or the eighth pad is configured to connect to the low-potential end. The ninth pad is configured to connect to the control integrated circuit. In addition, in embodiments of this application, a quantity of switching transistors connected on the current sampling link is not limited. For example, for meeting requirements of different control integrated circuits for current sampling precision, more switching transistors may be disposed on the current sampling link. The quantity of switching transistors is selected, so that a value of an equivalent turn-on resistance of the switching transistor on the current sampling link may be adjusted to further adjust a value of a sampled current flowing through the sampling circuit, to be compatible with control integrated circuits with different precision and ranges. Certainly, in this example, when the fourth switching transistor is disposed on the current sampling link, the fourth switching transistor may be connected in parallel to a structure formed by connecting the second switching transistor and the third switching transistor. Certainly, when the fourth switching transistor does not need to be connected on the current sampling link, for avoiding a waste of the fourth switching transistor, the fourth switching transistor may alternatively be connected in parallel to the first switching transistor as a part of a power current link.

In a possible implementation, the chip further includes a fourth switching transistor. The fourth switching transistor is disposed in a third region on the substrate, a drain of the fourth switching transistor is connected to a seventh pad, a source of the fourth switching transistor is connected to an eighth pad, and a gate of the fourth switching transistor is connected to a ninth pad. The fifth pad is configured to connect to the seventh pad. The eighth pad is configured to connect to the sampling circuit. The ninth pad is configured to connect to the control integrated circuit. In addition, in this example, the fourth switching transistor may alternatively be connected in series to a structure formed by connecting the second switching transistor and the third switching transistor.

In a possible implementation, the substrate further includes a third equal partition region, and the third region is the third equal partition region. For example, in this possible implementation, switching transistors connected on the current sampling link include three switching transistors: the second switching transistor, the third switching transistor, the fourth switching transistor. In this case, the substrate may be equally partitioned into three equal partition regions: the first equal partition region, the second equal partition region, and the third equal partition region; and the second switching transistor is disposed in the first equal partition region, the third switching transistor is disposed in the second equal partition region, and the third switching transistor is disposed in the third equal partition region.

In a possible implementation, to reduce a quantity of wire bonding times with a peripheral circuit through a pad, the fourth pad and the first pad share a same pad.

In a possible implementation, to reduce a quantity of wire bonding times with a peripheral circuit through a pad, the third pad and the sixth pad share a same pad.

In a possible implementation, to reduce a quantity of wire bonding times with a peripheral circuit through a pad, the seventh pad and the first pad share a same pad.

In a possible implementation, to reduce a quantity of wire bonding times with a peripheral circuit through a pad, the third pad and the ninth pad share a same pad.

In a possible implementation, for example, to improve an integration level of the chip, a switching transistor configured to perform high-voltage startup of the control integrated circuit may also be fabricated on the chip. In this case, the chip further includes a fifth switching transistor. A drain of the fifth switching transistor is connected to a tenth pad, a source of the fifth switching transistor is connected to an eleventh pad, and a gate of the fifth switching transistor is connected to a twelfth pad. The tenth pad is configured to connect to the high-potential end. The eleventh pad is configured to connect to the control integrated circuit. The twelfth pad is configured to connect to the control integrated circuit. Usually, the high-potential end is configured to supply power to the control integrated circuit through the fifth switching transistor, and the control integrated circuit is further configured to control the fifth switching transistor to be cut off.

In a possible implementation, the chip further includes a sixth switching transistor. A drain of the sixth switching transistor is connected to the tenth pad, a source of the sixth switching transistor is connected to the eleventh pad, and a gate of the sixth switching transistor is connected to the twelfth pad. The high-potential end is configured to supply power to the control integrated circuit through the sixth switching transistor, and the control integrated circuit is further configured to control the sixth switching transistor to be cut off. In this example, a high-voltage startup function may be implemented by connecting a plurality of switching transistors in parallel.

In a possible implementation, the source of the second switching transistor is connected to a thirteenth pad, and the thirteenth pad is configured to connect to a voltage clamping circuit. In some examples, there are a plurality of switching transistors connected in series on the current sampling link. Therefore, when the plurality of switching transistors connected in series are in a cut-off state, voltage division exists, and voltages between gates g and sources s of the plurality of switching transistors are not fixed. In this case, when there is an excessively high negative voltage between gates and sources of some switching transistors, gate breakdown may occur. For example, when the second switching transistor and the third switching transistor are connected in series, and the second switching transistor and the third switching transistor are cut off, a relatively high voltage exists on the source of the second switching transistor due to voltage division of the third switching transistor. Therefore, an excessively high negative voltage may exist between the gate and the source of the second switching transistor. In the solution provided in this implementation, the voltage clamping circuit is further properly disposed on the source of the second switching transistor, so that a voltage clamping circuit between the gate g and the source s of the second switching transistor is clamped within a proper voltage range, to avoid a gate breakdown problem caused by the excessively high negative voltage between the gate and the source of the second switching transistor. Certainly, in this example, the voltage clamping circuit may be disposed outside the chip, and is connected to the source of the second switching transistor through a pad connected to the source of the second switching transistor.

In a possible implementation, the chip further includes the voltage clamping circuit. The voltage clamping circuit is fabricated on the substrate, and the voltage clamping circuit is connected to the source of the second switching transistor; or the voltage clamping circuit is connected between the source and the gate of the second switching transistor. In this example, for avoiding gate breakdown that may be caused when there is an excessively high negative voltage between gates and sources of some switching transistors, the voltage clamping circuit may alternatively be disposed on the chip, and disposed on the source of the second switching transistor or between the gate and the source of the second switching transistor.

In a possible implementation, the voltage clamping circuit includes a capacitor or a diode. An anode of the diode is connected to the source of the second switching transistor.

In a possible implementation, a ratio of a gate width of the first switching transistor to a gate width of the second switching transistor ranges from 10:1 to 10000:1, and a ratio of the gate width of the first switching transistor to a gate width of the third switching transistor ranges from 10:1 to 10000:1. In this possible implementation, the first switching transistor connected in the power current loop has a larger current flowing capability and a lower turn-on impedance. Therefore, the gate width of the first switching transistor is far greater than the gate width of the second switching transistor or the third switching transistor. For example, the ratio of the gate width of the first switching transistor to the gate width of the second switching transistor ranges from 10:1 to 10000:1, and the ratio of the gate width of the first switching transistor to the gate width of the third switching transistor ranges from 10:1 to 10000: 1.

In a possible implementation, a ratio of a gate width of the first switching transistor to a gate width of the fifth switching transistor ranges from 10:1 to 10000:1. In this possible implementation, the first switching transistor connected in the power current loop has a larger current flowing capability and a lower turn-on impedance. Therefore, the gate width of the first switching transistor is far greater than the gate width of the fifth switching transistor. For example, the ratio of the gate width of the first switching transistor to the gate width of the fifth switching transistor ranges from 10:1 to 10000: 1.

In a possible implementation, the diode includes an eighth switching transistor, a source and a gate of the eighth switching transistor are connected to the anode of the diode, and a drain of the eighth switching transistor is connected to a cathode of the diode. A ratio of a gate width of the first switching transistor to a gate width of the eighth switching transistor ranges from 10:1 to 10000:1. In this possible implementation, the first switching transistor connected in the power current loop has a larger current flowing capability and a lower turn-on impedance, and the eighth switching transistor used in the voltage clamping circuit has a higher impedance. Therefore, the gate width of the first switching transistor is far greater than the gate width of the eighth switching transistor. For example, the ratio of the gate width of the first switching transistor to the gate width of the eighth switching transistor ranges from 10:1 to 10000: 1.

In a possible implementation, each switching transistor is a high-electron-mobility transistor.

According to a second aspect, a control chip is provided. The control chip is used in a switching power supply, and includes a package structure, the chip that is packaged in the package structure according to any one of the first aspect and the possible implementations of the first aspect, and a control integrated circuit.

In a possible implementation, the package structure further includes a sampling circuit.

According to a third aspect, a switching power supply is provided. The switching power supply includes a transformer, and the control chip according to any one of the second aspect and the possible implementation of the second aspect. The transformer includes a primary-side coil and a secondary-side coil, and the control chip is connected to the primary-side coil.

According to a fourth aspect, a power adapter is provided. The power adapter includes a housing, and the switching power supply mounted inside the housing according to any one of the first aspect and the possible implementations of the first aspect, or the control chip according to any one of the second aspect and the possible implementation of the second aspect.

According to a fifth aspect, a charging system is provided. The charging system includes a power adapter and a terminal device, the power adapter is connected to the terminal device, and the power adapter includes the power adapter according to the fourth aspect.

According to a sixth aspect, a wafer is provided. The wafer includes a plurality of chips that are distributed in an array according to any one of the first aspect and the possible implementations of the first aspect.

For technical problems resolved by the solutions provided in the second aspect to the sixth aspect and the possible implementations of the second aspect to the sixth aspect and implemented technical effects thereof, refer to the descriptions in any one of the first aspect and the possible implementations of the first aspect. Details are not described again.

According to a seventh aspect, a chip is provided, including: a substrate; a first switching transistor fabricated on the substrate, where a drain of the first switching transistor is connected to a first pad, a source of the first switching transistor is connected to a second pad, and a gate of the first switching transistor is connected to a third pad, where the first pad is configured to connect to a high-potential end, the second pad is configured to connect to a low-potential end, and the third pad is configured to connect to a control integrated circuit; and a second switching transistor and a third switching transistor that are fabricated on the substrate, where the third switching transistor is of a depletion mode, a drain of the first switching transistor and a drain of the second switching transistor are connected to the first pad, and a gate of the first switching transistor and a gate of the second switching transistor are connected to the third pad. A source of the second switching transistor is connected to a fifth pad, and the fifth pad is configured to connect to a sampling circuit. A drain of the third switching transistor is connected to a tenth pad, a source of the third switching transistor is connected to an eleventh pad, and a gate of the fifth switching transistor is connected to a twelfth pad. The tenth pad is configured to connect to the high-potential end. The eleventh pad is configured to connect to the control integrated circuit. The twelfth pad is configured to connect to the control integrated circuit. The high-potential end is configured to supply power to the control integrated circuit through the third switching transistor, and the control integrated circuit is further configured to control the third switching transistor to be cut off. The first pad is configured to connect to the high-potential end, the second pad is configured to connect to the low-potential end, and the third pad is configured to connect to the control integrated circuit. A turn-on state of the first switching transistor is controlled by using the control integrated circuit to form a power current loop between the high-potential end and the low-potential end. The gate of the second switching transistor is connected to the third pad, and the third pad is connected to the control integrated circuit. Therefore, a turn-on state of the second switching transistor is controlled by the control integrated circuit to form a current sampling link. The third switching transistor forms a power supply circuit for the control integrated circuit. In this way, the first switching transistor used in the power current loop, the second switching transistor used on the current sampling link, and the third switching transistor used for power supply of the control integrated circuit are disposed on one chip, so that costs of a co-packaged device are reduced, thereby improving reliability of the device.

### BRIEF DESCRIPTION OF DRAWINGS

FIG. 1 is a diagram of a structure of a charging system according to an embodiment of this application;
FIG. 2 is a diagram of a structure of an electronic device according to an embodiment of this application;
FIG. 3 is a diagram of a structure of a Type-C interface according to an embodiment of this application;
FIG. 4 is a diagram of a structure of a switching power supply according to an embodiment of this application;
FIG. 5 is a diagram of a structure of a switching power supply according to another embodiment of this application;
FIG. 6 is a diagram of a structure of a switching power supply according to still another embodiment of this application;
FIG. 7 is a diagram of a structure of a switching power supply according to yet another embodiment of this application;
FIG. 8 is a fitting curve diagram of FOMs of an HEMT device and a Si MOSFET at different cut-off voltages according to an embodiment of this application;
FIG. 9 is a fluctuation curve diagram of a turn-on impedance of a GaN HEMT device with a process or a material defect according to an embodiment of this application;
FIG. 10A to FIG. 11B each are a diagram of a chip provided in Example 1 according to an embodiment of this application;
FIG. 12A and FIG. 12B each are a diagram of a cell structure of an HEMT according to an embodiment of this application;
FIG. 13A and FIG. 13B each are a diagram of a cross-sectional structure of a chip provided in Example 1 according to an embodiment of this application;
FIG. 14A to FIG. 15B each are a diagram of a top-view structure of a chip provided in Example 1 according to an embodiment of this application;
FIG. 16 is a flowchart of a method for fabricating a chip provided in Example 1 according to an embodiment of this application;
FIG. 17A to FIG. 18 each are a diagram of a chip provided in Example 2 according to an embodiment of this application;
FIG. 19A to FIG. 19D each are a diagram of a cross-sectional structure of a chip provided in Example 2 according to an embodiment of this application;
FIG. 20A and FIG. 20B each are a diagram of a top-view structure of a chip provided in Example 2 according to an embodiment of this application;
FIG. 21A to FIG. 21D are diagrams of current sampling and simulation of a chip provided in Example 2 according to an embodiment of this application;
FIG. 22A and FIG. 22B each are a diagram of distribution of an equivalent turn-on impedance of a chip provided in Example 2 according to an embodiment of this application;
FIG. 23A to FIG. 23D each are a diagram of a chip provided in Example 3 according to an embodiment of this application;
FIG. 24 is a diagram of a cross-sectional structure of a chip provided in Example 3 according to an embodiment of this application;
FIG. 25 is a diagram of a top-view structure of a chip provided in Example 3 according to an embodiment of this application;
FIG. 26 is a flowchart of a method for fabricating a chip provided in Example 3 according to an embodiment of this application;
FIG. 27A to FIG. 27D are simulation diagrams of a chip provided in Example 3 according to an embodiment of this application;
FIG. 28A and FIG. 28B each are a diagram of a chip provided in Example 4 according to an embodiment of this application;
FIG. 29 is a diagram of a cross-sectional structure of a chip provided in Example 4 according to an embodiment of this application;
FIG. 30 is a diagram of a top-view structure of a chip provided in Example 4 according to an embodiment of this application;
FIG. 31 is a flowchart of a method for fabricating a chip provided in Example 4 according to an embodiment of this application;
FIG. 32 is a diagram of a structure of an HEMT provided in Example 4 according to an embodiment of this application;
FIG. 33A and FIG. 33B each are a feature curve diagram of an HEMT device provided in Example 4 according to an embodiment of this application;
FIG. 34 is a diagram of a structure of a control chip provided in Example 5 according to an embodiment of this application; and
FIG. 35 is a diagram of a structure of a wafer provided in Example 6 according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second" mentioned below are merely intended for ease of description, and shall not be understood as an indication or implication of relative importance or implicit indication of a quantity of indicated technical features. Therefore, a feature limited by "first", "second", or the like may explicitly or implicitly include one or more features. In embodiments of this application, unless otherwise specified in the context, in the entire specification and claims, the term "include" is interpreted as "open and inclusive", that is, "include, but not limited to". Unless otherwise expressly specified and limited, the term "connect" should be understood in a broad sense. For example, a "connection" may be a fixed connection, may be a detachable connection, or may be an integrated connection; and may be a direct connection, or an indirect connection through an intermediate medium.

In this specification, example implementations are described with reference to sectional views and/or plan views and/or equivalent circuit diagrams as idealized example accompanying drawings. In the accompanying drawings, for clarity, thicknesses of layers and regions are enlarged. Therefore, a change of a shape in the accompanying drawings due to, for example, a manufacturing technique and/or tolerance may be envisaged. Therefore, example implementations should not be construed as being limited to a shape of a region shown in this specification, but rather include shape deviations due to, for example, manufacturing. Therefore, the regions shown in the accompanying drawings are essentially examples, and their shapes are not intended to show actual shapes of regions of a device, and are not intended to limit a scope of the example implementations.

Before embodiments of this application are described, terms that may appear next are defined first.

2DEG (two-dimensional electron gas): A discontinuous energy-band structure in a semiconductor heterojunction structure forms a potential well on an interface, and electrons are confined to the potential well, so that the electrons move basically in a direction parallel to the interface and an electron movement direction in a direction perpendicular to the interface is restricted.

Threshold voltage: Usually, a gate voltage corresponding to a midpoint of a turning region in which an output current changes sharply with an input voltage in a transmission characteristic curve is referred to as the threshold voltage.

Nucleation layer: A thin layer structure on a substrate for forming GaN crystals.

Buffer layer: Has a high resistance, and is used for improving a breakdown characteristic of a device. For example, a GaN or AlGaN layer that is intentionally doped forms a high resistance state.

Channel layer: Is used for transferring a charge carrier, for example, may be a GaN layer that is not be intentionally doped.

Barrier layer: Used for confining a charge carrier at a channel layer.

Passivation layer: An insulating dielectric layer, which is used for covering a semiconductor surface or providing a galvanic isolation function.

Field plate: Distribution of surface potentials is changed to increase a curvature radius of a curved junction, thereby suppressing concentration of a surface electric field.

Cell: A smallest characteristic structure that is periodically arranged in a semiconductor.

Gate width: A gate width parallel to a gate semiconductor layer and perpendicular to a connection line between a source and a drain.

Enhanced mode: A state in which there is no conduction current between a source and a drain of a switching transistor when no voltage is applied to a gate.

Depletion mode: A state in which there is a conduction current between a source and a drain of a switching transistor when no voltage is applied to a gate.

Turn-on impedance: or turn-on resistance, namely, an impedance from a source to a drain when a gate of a device (such as a MOS transistor) inputs an enable signal.

Die: The die (Die) is a chip produced in a foundry (foundry) and a chip not packaged after a wafer (wafer) is cut and tested. The die may allow an internal circuit of the chip to connect to a packaged pin (pin) through wire bonding (bonding). After bonding, the die is packaged by using a black packaging material, and the packaged pin is exposed. In embodiments of this application, the die is also referred to as a chip.

The following describes technical solutions of embodiments in this application with reference to the accompanying drawings.

A switching power supply and a control chip provided in embodiments of this application may be used in a power adapter of an electronic device such as a mobile phone, a tablet computer, a notebook computer, an ultra-mobile personal computer (ultra-mobile personal computer, UMPC), a handheld computer, a netbook, a personal digital assistant (personal digital assistant, PDA), a wearable electronic device, or a virtual reality device.

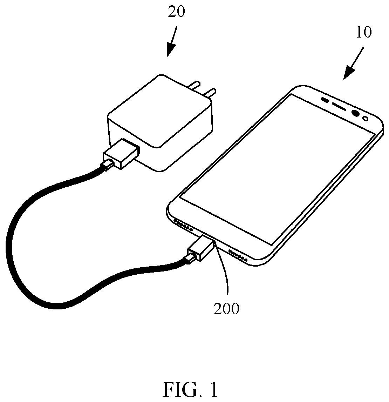

With reference to FIG. 1, embodiments of this application may be applied to a charging system including a power adapter 20 and an electronic device 10. Usually, the power adapter 20 includes a housing and a switching power supply mounted inside the housing. An input side of the switching power supply is usually connected to a mains supply through a prong disposed on the housing, and an output side of the switching power supply is connected to the electronic device through a plug 200. In addition, the switching power supply may be soldered on a printed circuit board PCB in the housing.

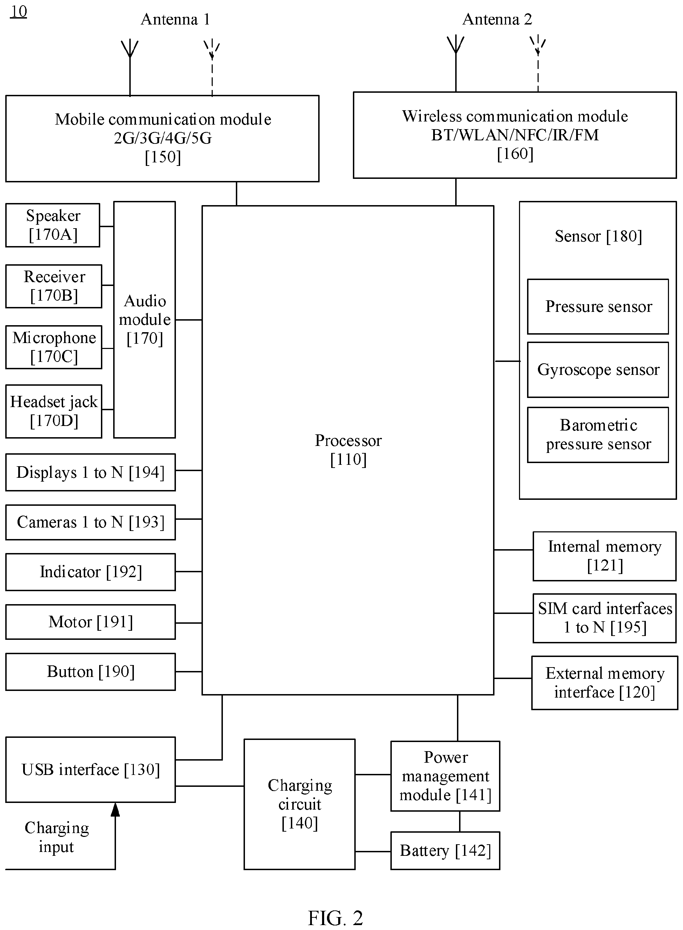

For example, FIG. 2 is a diagram of a structure of the electronic device 10.

As shown in FIG. 2, the electronic device 10 may include a processor 110, an external memory interface 120, an internal memory 121, a universal serial bus (universal serial bus, USB) interface 130, a charging circuit 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor 180, a button 190, a motor 191, an indicator 192, a camera 193, a display 194, a subscriber identity module (subscriber identity module, SIM) card interface 195, and the like.

The structure shown in this embodiment does not constitute a specific limitation on the electronic device 10. In some other embodiments of this application, the electronic device 10 may include more or fewer components than those shown in the figure, or some components may be combined, or some components may be split, or there may be a different component arrangement. The components shown in the figure may be implemented by hardware, software, or a combination of software and hardware. In addition, an interface connection relationship between modules illustrated in embodiments of the present invention is merely an example for description, and does not constitute a limitation on the structure of the electronic device 10.

The USB interface 130 is an interface that conforms to a USB standard specification, and may be specifically a mini USB interface, a micro USB interface, a USB Type-C interface, or the like. The USB interface 130 may be configured to connect to the power adapter 20 to charge the electronic device 10, or may be configured to perform data transmission between the electronic device 10 and a peripheral device, or may be configured to connect to a headset to play audio through the headset.

The charging circuit 140 is configured to receive a charging input from a charger. The charger may be a wireless charger or a wired charger. When charging the battery 142, the charging circuit 140 may further supply power to the electronic device 10 by using the power management module 141. In some embodiments of wired charging, the charging circuit 140 may receive a charging input of the wired charger through the USB interface 130. In some embodiments of wireless charging, the charging circuit 140 may receive a wireless charging input through a wireless charging coil of the electronic device 10. In some examples of this application, the wireless charger may include the power adapter 20, and a wireless charging stand or a wireless charging pad that is connected to the power adapter 20 through the USB interface 130. A transmitting coil configured to wirelessly charge the electronic device 10 is disposed on the wireless charging stand or the wireless charging pad.

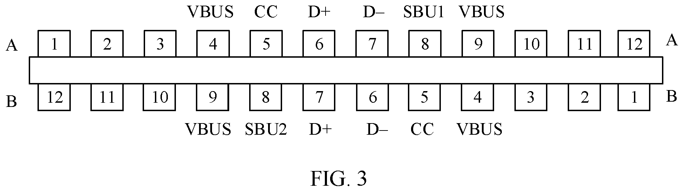

In addition, with reference to FIG. 1, to enable the electronic device 10 to be coupled to the power adapter 20 (a charger), the power adapter 20 may include the plug 200 that is plugged into the USB interface 130 of the electronic device (or a wireless charging stand). As shown in FIG. 3, the plug may be a Type-C interface. The Type-C interface may include a CC pin shown in FIG. 3. The CC pin may identify a type of an external device coupled to the Type-C interface. In addition, as shown in FIG. 3, each of a side A and a side B of the Type-C interface includes two symmetrically arranged VBUS pins (which are used for providing USB voltages, include a pin 4 and a pin 9, and are used as voltage output ends in embodiments of this application), a CC pin (a pin 5), a D+ pin (a pin 6 on the side A or a pin 7 on the side B), a D- pin (a pin 7 on the side A or a pin 6 on the side B), and an SBU pin (where a pin 8 is a spare pin, which is marked as an SBU 1 on the side A and marked as an SBU 2 on the side B). Moreover, the plug may further have other pins for grounding, idleness, and the like. When the plug 200 of the power adapter 20 is inserted into the USB interface 130 of the electronic device 10, the electronic device 10 may be charged.

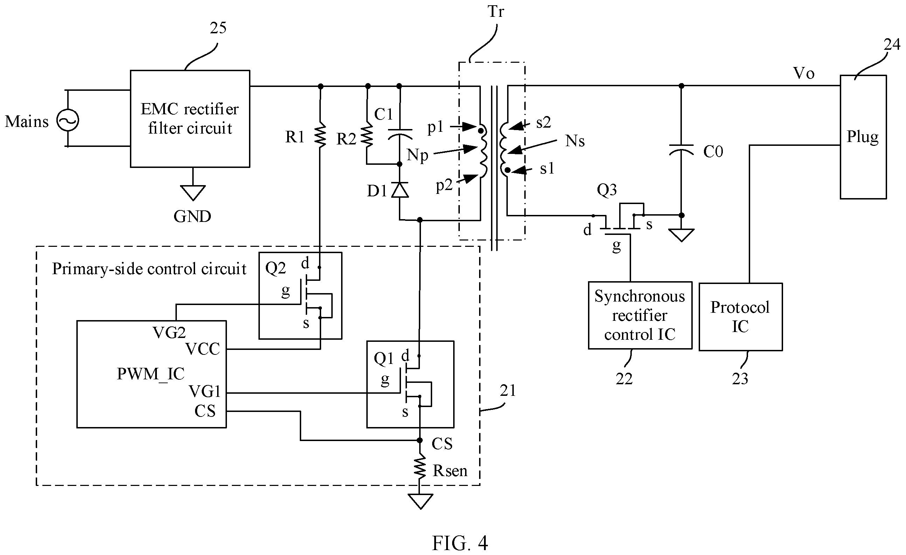

With reference to FIG. 4, a switching power supply is provided. A flyback switching power supply is used as an example, and includes a transformer Tr, a primary-side control circuit 21, a synchronous control integrated circuit (integrated circuit, IC) 22, and a protocol integrated circuit (protocol IC) 23.

The transformer Tr includes a primary-side coil Np and a secondary-side coil Ns. Each of the primary-side coil Np and the secondary-side coil Ns has two ends. In a detailed example, one end of each of the primary-side coil Np and the secondary-side coil Ns is referred to as a dotted terminal, and the other end of each of the primary-side coil Np and the secondary-side coil Ns is referred to as an undotted terminal. Certainly, in another example, one end of each of the primary-side coil Np and the secondary-side coil Ns may alternatively be referred to as an undotted terminal, and the other end of each of the primary-side coil Np and the secondary-side coil Ns may alternatively be referred to as a dotted terminal. A dotted terminal p1 of the primary-side coil Np is connected to a power supply end. For example, the power supply end may supply power after a mains flows through an EMC rectifier filter circuit 25. An undotted terminal p2 of the primary-side coil Np is connected to the primary-side control circuit 21. An undotted terminal s2 of the secondary-side coil Ns is connected to a voltage output end Vo. For example, the voltage output end Vo may be a VBUS pin in a plug 24. A dotted terminal s1 of the secondary-side coil Ns is connected to ground GND through a third switching transistor Q3, and an output capacitor C0 is further disposed between the undotted terminal s1 of the secondary-side coil Ns and the ground GND.

The primary-side control circuit 21 includes a control integrated circuit (for example, which may be a pulse-width modulation integrated circuit (pulse-width modulation IC, PWM_IC), where an example in which the control integrated circuit is the PWM_IC is used for description in all solutions below), a first switching transistor Q1, a second switching transistor Q2, and a sampling circuit. For example, the sampling circuit may be a sampling resistor Rsen. Certainly, in the solutions below, an example in which the sampling circuit is the sampling resistor Rsen is used for description, and the sampling circuit is not limited to the sampling resistor Rsen. Specifically, the undotted terminal p2, as a high-potential end, of the primary-side coil Np is connected to the ground GND through the Q1 and the sampling resistor Rsen. For example, a drain (drain, d) of the Q1 is connected to the undotted terminal p2 of the primary-side coil Np, the sampling resistor Rsen is connected in series between a source (source, s) of the Q1 and the ground GND, and a gate (gate, g) of the Q1 is connected to a VG1 pin of the PWM_IC. A drain d of the Q2 is connected to the dotted terminal p1 (which serves as a high-potential end, where in some examples, the drain d of the Q2 may alternatively be connected to the undotted terminal p2 of the primary-side coil Np) of the primary-side coil Np through a resistor R1, a gate g of the Q2 is connected to a VG2 pin of the PWM_IC, and a source s of the Q2 is connected to a power supply VCC pin of the PWM_IC.

In addition, as shown in FIG. 4, the EMC rectifier filter circuit 25 is further disposed between the power supply end that provides the mains and the dotted terminal p1 of the primary-side coil Np. A freewheeling loop is further connected between the dotted terminal p1 and the undotted terminal p2 of the primary-side coil Np. The freewheeling loop includes a capacitor C1 and a diode D1 that are connected in series to the dotted terminal p1 and the undotted terminal p2. An anode of the diode D1 is connected to the undotted terminal p2 of the primary-side coil Np. The freewheeling loop further includes a resistor R2 connected in parallel to the capacitor C1.

In this way, an alternating current mains is converted into a direct current after flowing through the EMC rectifier filter circuit 25 (which filters an alternating current into a direct current). A control signal (for example, which may be a pulse width modulation (pulse width modulation, PWM) signal) output by the VG1 pin of the PWM_IC controls turn-on or cut-off of the Q1; and a control signal (for example, which may be a PWM signal) output by the synchronous rectifier control IC 22 controls turn-on or cut-off of the Q2. A flyback working principle of the switching power supply is as follows: During a turn-on period of the Q1, energy is stored in the transformer Tr through the primary-side winding Np. At this time, the Q3 is cut off, and an output power supply of the plug 24 is maintained by the capacitor C0. During a turn-off period of the Q1, the Q3 is turned on, and the energy stored in the transformer Tr is released through the secondary-side winding Ns. During the turn-off period of the Q1, the primary-side coil forms a loop through the freewheeling loop to keep a current uninterrupted. The PWM_IC controls a turn-on duty cycle or a switching frequency of the Q1 to implement a stable power output. To adjust the output voltage, after the protocol IC 23 interacts with the electronic device to drive the output voltage, and the synchronous rectifier control IC 22 controls a turn-on duty cycle or a switching frequency of the Q3 to adjust the output voltage. In addition, to ensure that the circuit works normally and to prevent performance deterioration or even burning of circuit components due to overcurrent and another phenomena, high-voltage startup protection for the IC and overcurrent protection for the circuit are required. In this solution, a Q2 high-voltage startup transistor is mainly used to prevent an input high voltage flowing through the R1 from being directly flowed to the VCC pin of the IC to implement high-voltage startup protection, and a current is detected through the Rsen. A CS pin of the PWM_IC is further connected to the source s (a node CS in FIG. 4) of the Q1. When detecting that a current flowing through the Q1 exceeds a protection current, the PWM_IC may actively control the Q1 to be turned off, disconnect the mains, or start another security control mechanism to perform overcurrent protection on the circuit.

The foregoing mainly describes a status of the switching power supply shown in FIG. 4 when the switching power supply works normally. In addition, usually, during initial power-on, because the PWM_IC is not powered on yet, the PWM_IC needs to be powered on through the Q2. A power supply voltage of the VCC pin of the PWM_IC is at a low level, a control signal output by the PWM_IC to the Q1 through the VG1 is also at a low level, the Q1 is cut off, and the transformer Tr has no current. The Q2 is a depletion-mode device, that is, turned on when a voltage of the gate is 0 V. After the mains supplies a high-voltage direct current to the primary side of Np through the EMC rectifier filter circuit 25, a rectified voltage signal VDD flows into the VCC pin through the Q2 to charge a startup circuit of the PWM_IC, so that the power supply voltage of the VCC pin of the PWM_IC is raised from the low level to a high level. At the same time, a voltage of the source s of the Q2 is raised until the voltage of the source s of the Q2 relative to a voltage Vgs of the gate g of the Q2 is close to a threshold voltage Vth of the Q2, and the Q2 is in a half-turn-on or turn-off state. In this case, although voltages Vds of two ends, namely, the source and the drain of the Q2, may be very high. Because an impedance of the Q2 in the half-turn-on or turn-off state is high, a startup current is basically ignored, that is, the startup circuit is no longer charged. In this case, a potential of the source s of the Q2 may be approximately the threshold voltage Vth of the Q2+VG2, or may be adjusted to a required voltage through an internal circuit of the PWM_IC (another element of the startup circuit may be formed by a Si-based PWM_IC, and details are not described herein), so that a VCC voltage is maintained at a required level, and the PWM_IC starts to work normally. After the PWM_IC starts to work normally, the PWM_IC controls the switching power supply to provide a normal power supply voltage to the VCC pin (for this section, reference may be made to a conventional PWM_IC power supply manner, and details are not described in embodiments of this application).

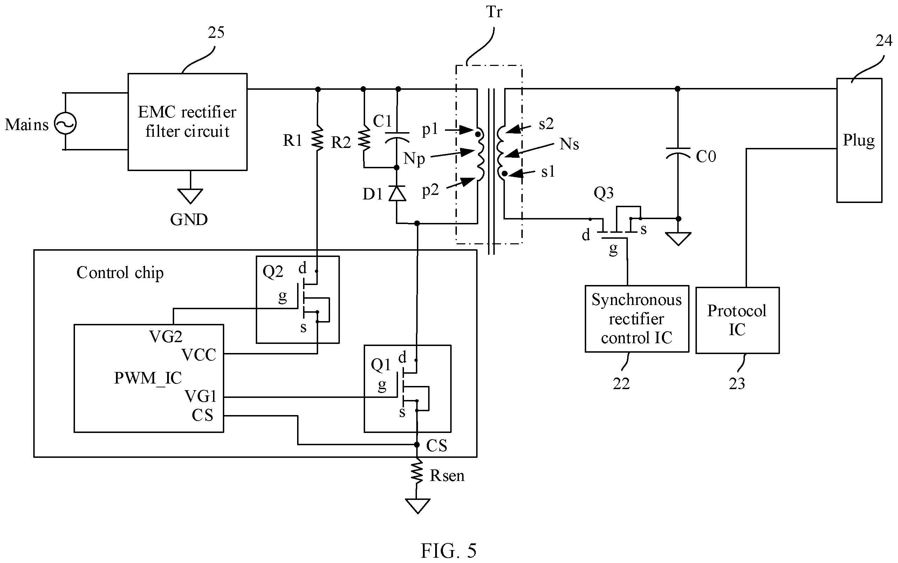

In the foregoing process, when the PWM_IC works, the control signal output by the VG1 pin is provided to the Q1 to control the turn-on duty cycle or the switching frequency of the Q1, thereby implementing a stable power output. Because the sampling resistor Rsen is connected in series to the Q1, all power currents flowing through the Q1 flow through the Rsen. Usually, an impedance of the Rsen ranges from 100 mohm to 200 mohm, which greatly affects a link loss. In addition, with reference to FIG. 5, for simplifying a layout of a peripheral circuit and improving an integration level of the circuit, the PWM_IC, the Q1, and the Q2 may be packaged together in a same package structure by using a package structure to form a co-packaged device (to form a control chip). Certainly, in some examples, the Rsen may also be packaged in the co-packaged device. In this way, heat generated due to a loss on the Rsen causes an obvious temperature rise of the co-packaged device.

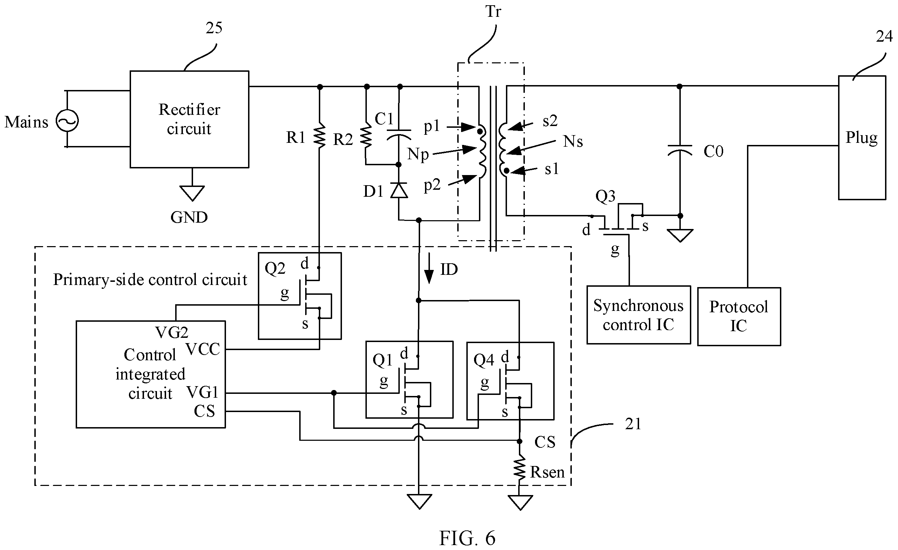

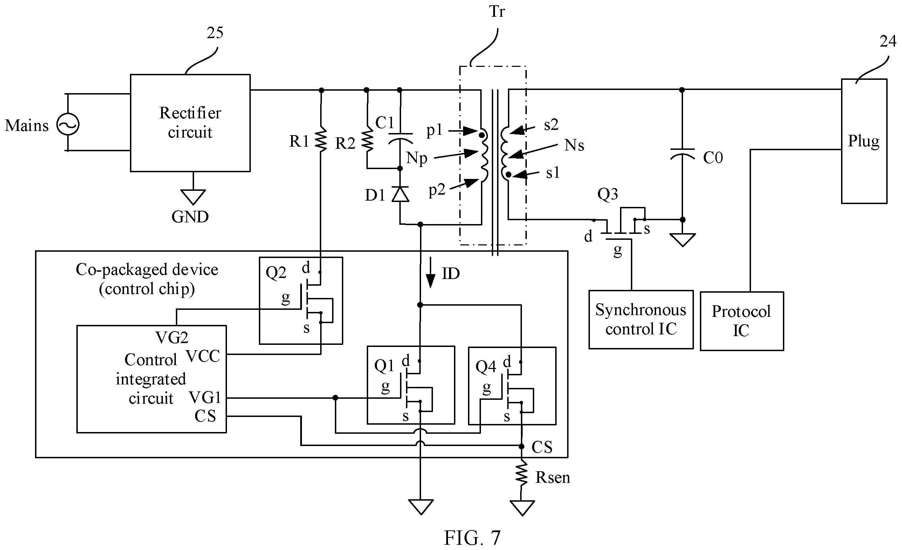

With reference to FIG. 6, for reducing impact of the link loss and the temperature rise on working stability of the switching power supply, the following optimization is performed: The first switching transistor Q1 in the primary-side control circuit 21 is disposed between the undotted terminal p2 of the primary-side coil and the ground GND to serve as a power current link, and a current sampling link formed by disposing a fourth switching transistor Q4 and the sampling resistor Rsen is connected in series between the undotted terminal p2 of the primary-side coil and the ground GND. A turn-on impedance of the Q1 is RFET, and a turn-on impedance of the Q4 is K*RFET (where K is a fixed coefficient and K>>1). With reference to FIG. 6, the source s of the Q1 is directly connected to the ground GND, the drain d of the Q1 and a drain d of the Q4 are connected to each other and then connected to the undotted terminal p2 of the primary-side coil; the gate g of the Q1 and a gate g of the Q4 are connected to each other and then connected to the VG1 pin of the PWM_IC; and a source s of the Q4 is connected to one end of the Rsen, and the other end of the Rsen is directly connected to the ground GND. Device characteristic structures of the Q1 and the Q4 may be consistent, but a chip area of the Q1 >> a chip area of the Q4, so that resistance values of the Q4 and the Q1 are in a K-fold relationship (where K>>1) when a device is turned on. Therefore, when the Q1 and the Q4 are turned on, a current ID output by the undotted terminal p2 of the primary-side coil mainly flows through the power current link formed by the Q1 while a current ISEN of the current sampling link (a circuit formed by the Q4 and the Rsen) << the ID. It can be seen that a resistance of the Rsen greatly reduces a link loss of the current sampling link, thereby greatly reducing impact of an impedance of the Rsen on system efficiency. Particularly, with reference to FIG. 7, when the PWM_IC, the Q1, the Q2, and the Q4 are packaged together in a same unit to form a co-packaged device (to form a control chip), heat generated due to a loss on the Rsen significantly reduces a temperature rise of the co-packaged device.

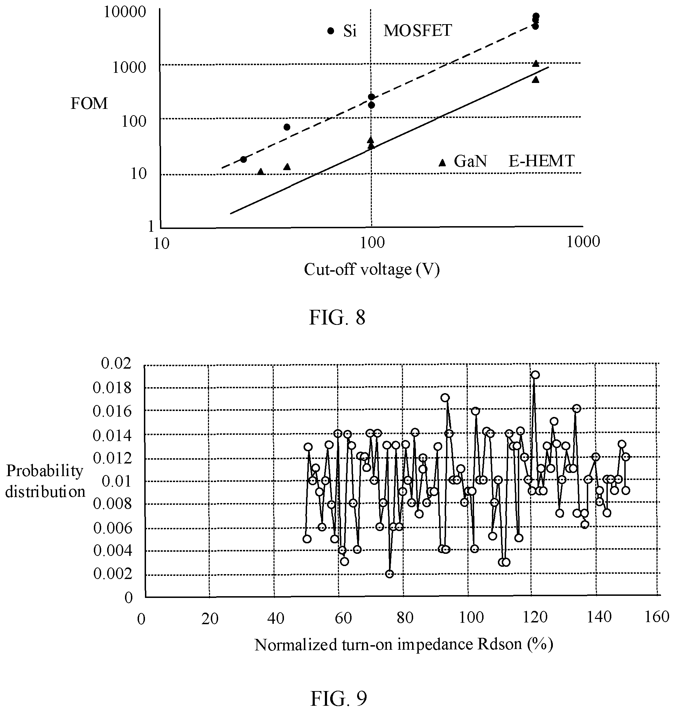

The Q1, the Q2, the Q3, and the Q4 in FIG. 4 to FIG. 7 are usually field-effect transistors (field-effect transistors, FETs). For example, a silicon (Si)-based oxide-semiconductor field-effect transistor (metal-oxide-semiconductor field-effect transistor, MOSFET) is usually used in the industry. However, for the MOSFET prepared based on the Si material, performance such as a turn-on impedance has basically reached a physical limit of the Si material. When the Si MOSFET is turned on, a turn-on resistance is large, resulting in a large turn-on loss, low circuit efficiency, and severe heat generation. Especially, when the circuit works, a main power of the primary-side coil flows through the Q1 (in FIG. 7, the main power flows through the Q1 and the Q4), and a loss on the Q1 is more obvious. However, a wide-bandgap (wide-bandgap, WBG) semiconductor material represented by GaN (Gallium nitride) becomes a most potential candidate in a new-generation power electronic device because of advantages such as a larger bandgap width, a higher breakdown field strength, and a higher electron saturation rate. FIG. 8 shows a fitting curve of figure of merits (figure of merits, FOMs) of a typical GaN-based high-electron-mobility transistor (high electron mobility transistor, HEMT) device and a Si MOSFET at different cut-off voltages (blocking voltages, in a unit of V), where FOM=Rdson*Qg, Rdson indicates a turn-on resistance of a transistor, and Qg indicates a gate electric charge. Obviously, the FOM of the GaN HEMT is lower than that of the Si MOSFET at a same cut-off voltage. Therefore, it is necessary to use the GaN HEMT for the Q1 and the Q4, to further reduce a device loss and improve circuit efficiency.

However, based on the switching power supply shown in FIG. 6, the PWM_IC, the Q1, the Q2, and the Q4 may be separately fabricated on an independent die (Die) to form an independent device respectively. Certainly, as described above, for improving the integration level, as shown in FIG. 7, dies (Dies) of the PWM_IC, the Q1, the Q2, and the Q4 may alternatively be co-packaged on a same package substrate to form a co-packaged device (to form a control chip). In the co-packaged device, the Q1 and the Q4 may be the GaN HEMT, and the PWM_IC and the Q2 may still be the Si-based device. Both the Q1 and the Q4 are the GaN HEMT. Therefore, for further improving the integration level, the Q1 and the Q4 may alternatively be fabricated on a same die. However, the GaN HEMT is a device with many defects. Based on the switching power supply shown in FIG. 7, it can be learned that a turn-on impedance value of the Q4 is relatively large, and a chip size of a die is relatively small. Then, when the Q1 and the Q4 are fabricated on the same die, the Q4 is placed at a different location relative to the Q1. Because material defects at different locations on the die are different, fluctuation of a turn-on resistance (or a dynamic turn-on resistance) of the Q4 is greatly affected, which finally affects precision of a value of the fixed coefficient K. As shown in FIG. 9, a fluctuation curve of a turn-on impedance of a GaN HEMT device with a process or a material defect (where a horizontal axis indicates a turn-on impedance (represented as 1±50% of an average value of the turn-on impedance), and a vertical axis indicates a distribution probability) is assumed. It can be learned that a normalized turn-on impedance Rdson randomly fluctuates within a range of R0*(1±50%), where R0 indicates the average value of the turn-on impedance. Therefore, after large-scale mass production, the turn-on impedance of the Q4 fluctuates greatly, which greatly affects current sampling precision of the current sampling link.

For resolving the foregoing current sampling precision problem, an embodiment of this application provides a chip for replacing the die integrated by the Q1 and the Q4 in FIG. 7, to ensure current sampling precision of a primary-side current of the switching power supply.

The following describes the chip provided in embodiments of this application by using several detailed examples.

### Example 1:

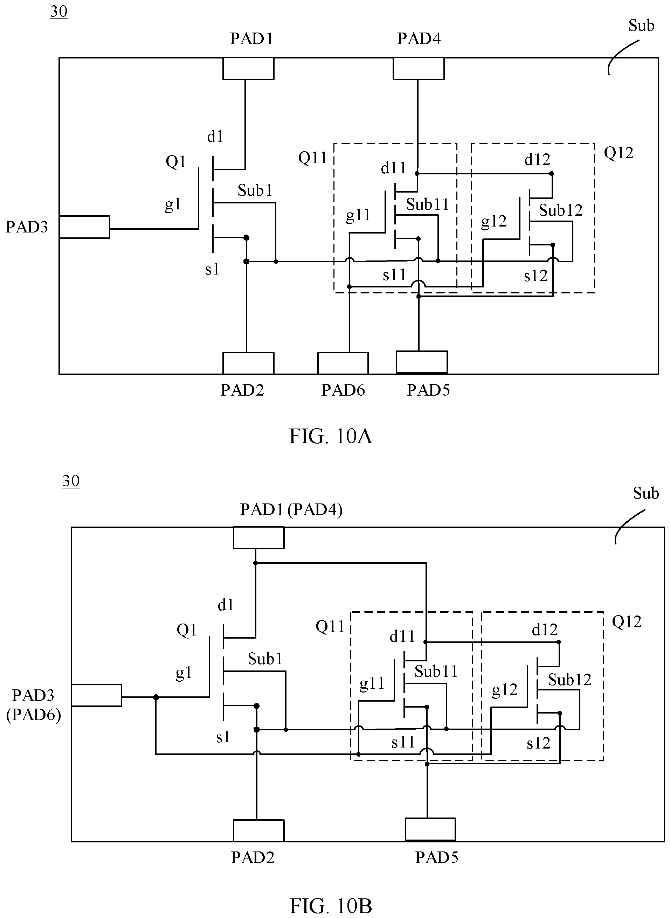

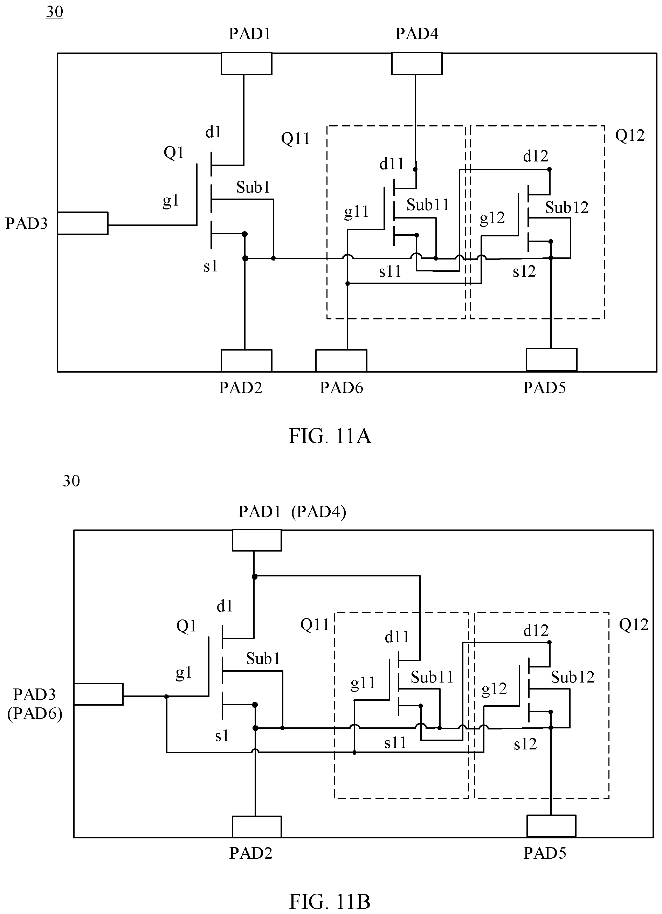

FIG. 10A, FIG. 10B, FIG. 11A, and FIG. 11B each are a schematic of a circuit topology of the chip 30. The chip 30 includes a substrate Sub; and a first switching transistor Q1, a second switching transistor Q11, and a third switching transistor Q12 that are fabricated on the substrate.

The first switching transistor Q1 includes a drain d1, a source s1, and a gate g1. The drain d1 of the Q1 is connected to a first pad PAD1, the source s1 of the Q1 is connected to a second pad PAD2, and the gate g1 of the Q1 is connected to a third pad PAD3. The PAD2 is configured to connect to a low-potential end (for example, ground GND), and the PAD1 is configured to connect to a high-potential end, for example, may be the undotted terminal p2 of the primary-side coil Np of the switching power supply in FIG. 7. The PAD3 is configured to connect to a control integrated circuit, for example, the PWM_IC of the switching power supply. When the PWM_IC controls the Q1 to be in a turn-on state, the primary-side coil of the switching power supply is connected to the ground GND, where the current ID of the undotted terminal p2 of the primary-side coil mainly forms a power current loop through the Q1.

The second switching transistor Q11 includes a drain d11, a source s11, and a gate g11, and the third switching transistor Q12 includes a drain d12, a source s12, and a gate g12.

In FIG. 10A, the Q11 and the Q12 are connected in parallel. Specifically, a drain of the Q11 and a drain of the Q12 (the drain d11 of the Q11 and the drain d12 of the Q12) are connected to a PAD4, a source of the Q11 and a source of the Q12 (the source s11 of the Q11 and the source s12 of the Q12) are connected to a PAD5, and a gate of the Q11 and a gate of the Q12 (the gate g11 of the Q11 and the gate g12 of the Q12) are connected to a PAD6.

In FIG. 11A, the Q11 and the Q12 are connected in series. The drain d11 of the Q11 is connected to the PAD4, the drain d12 of the Q12 is connected to the source s11 of the Q11, the source s12 of the Q12 is connected to the PAD5, and a gate of the Q11 and a gate of the Q12 (the gate g11 of the Q11 and the gate g12 of the Q12) are connected to the PAD6.

The PAD4 is configured to connect to the high-potential end, for example, may be the undotted terminal p2 of the primary-side coil Np in FIG. 7. The PAD5 is configured to connect to a sampling resistor Rsen, for example, may be connected to the node CS in FIG. 7, and is connected to the ground through the Rsen. The PAD6 is configured to connect to the PWM_IC of the switching power supply. When the PWM_IC is configured to control the Q11 and the Q12 to be in a turn-on state, the undotted terminal p2 of the primary-side coil Np of the switching power supply is connected to the sampling resistor Rsen. A part of a current at the undotted terminal p2 of the primary-side coil flows through the Q11, the Q12, and the Rsen to form a current sampling link. In some examples, for reducing a quantity of times of wire bonding between a PAD and a peripheral circuit, the PAD1 and the PAD4 may also be shared, and as shown in FIG. 10B and FIG. 11B, a drain of the Q11 and a drain of the Q12 are connected to the PAD1 (the PAD4); and the PAD6 and the PAD3 may also be shared, and as shown in FIG. 10B and FIG. 11B, a gate of the Q11 and a gate of the Q12 are connected to the PAD3 (the PAD6).

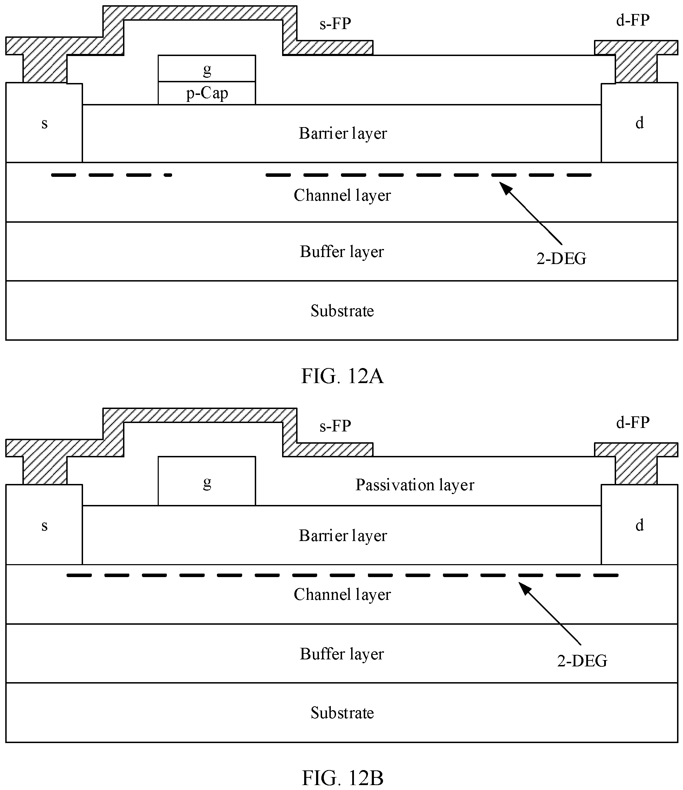

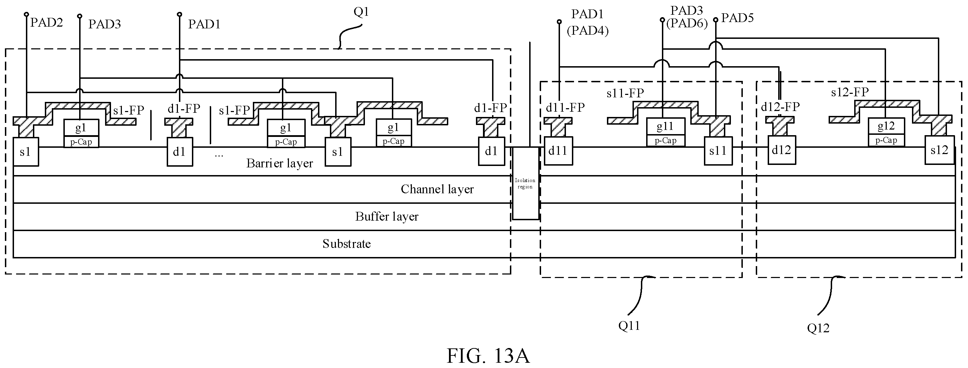

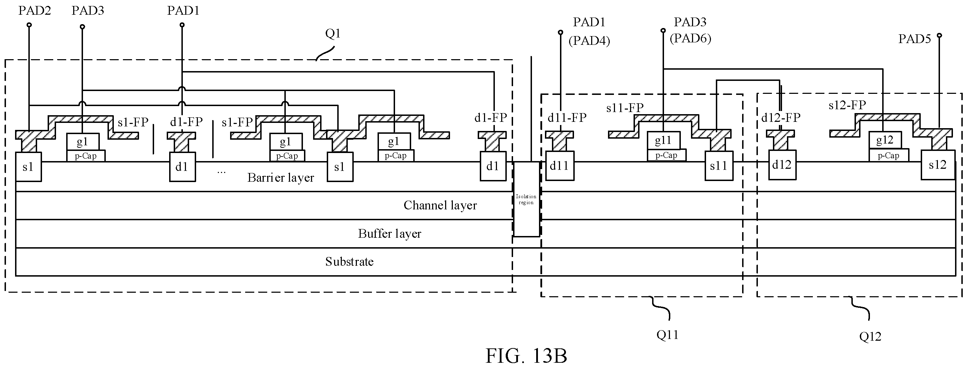

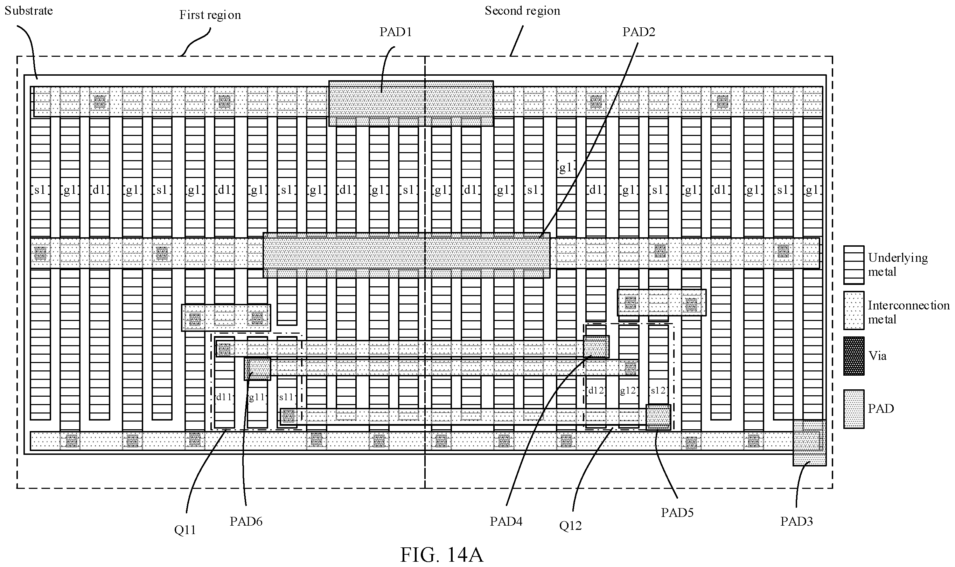

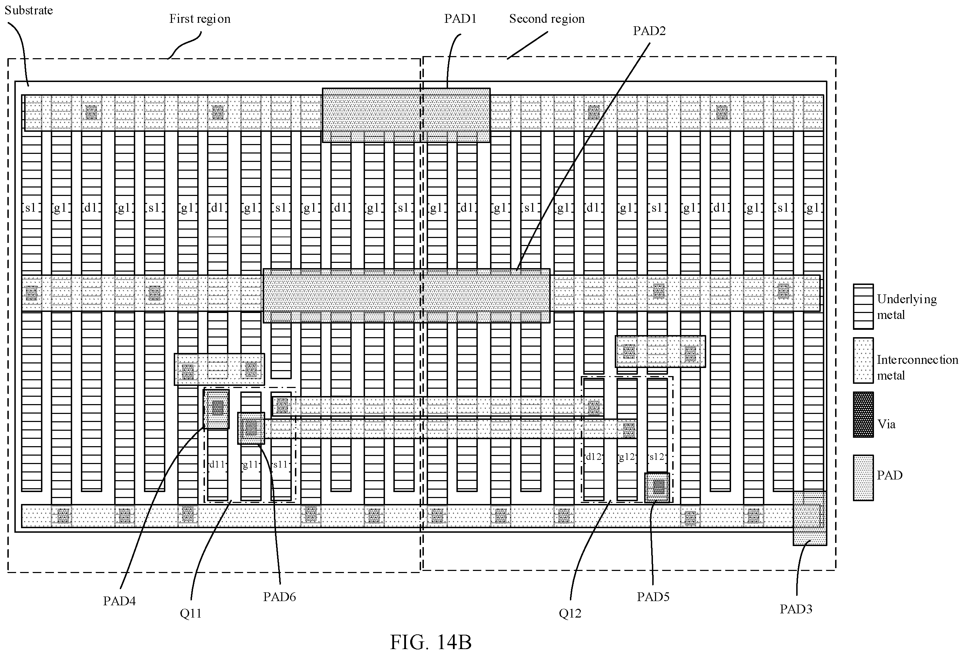

In addition, in Example 1, the Q1, the Q11, and the Q12 each may be an HEMT. In embodiments of this application, the Q1, the Q11, and the Q12 are not limited to an enhanced-mode HEMT, for example, may be a p-type gate HEMT; or the Q1, the Q11, and the Q12 each may alternatively be a depletion-mode HEMT, for example, a Schottky gate HEMT. FIG. 12A provides a cell structure of an enhanced-mode HEMT. The HEMT includes a substrate (substrate, Sub) and a plurality of epitaxial layers disposed on the substrate. The plurality of epitaxial layers mainly include a buffer layer (buffer layer), a channel layer (channel layer), and a barrier layer (barrier layer) that are disposed on the substrate. Electrodes such as a gate (Gate, g), a source (Source, s), and a drain (Drain, d) are disposed on the epitaxial layer. The electrode is covered with a passivation layer (passivation layer). A material of the substrate is usually a conductor or a semiconductor. Therefore, an electrode formed by the substrate is referred to as a substrate electrode Sub. A substrate electrode Sub1 of the Q1 is coupled to the source s1. No matter whether the HEMT device is turned on or turned off, a potential of the substrate Sub1 is usually equal to that of the source s1. In addition, the Q1, the Q11, and the Q12 are fabricated on a same substrate. To be specific, substrate electrodes (the Sub1, a Sub11, and a Sub12) of the Q1, the Q11, and the Q12 are a same electrode or electrically interconnected. Certainly, the HEMT shown above is merely an example. In some examples, the epitaxial layer may further have more layer structures. For example, a nucleation layer may be further disposed between the buffer layer and the substrate. A GaN HEMT is used as an example. The channel layer usually uses GaN, the barrier layer usually uses aluminium gallium nitride (AlGaN), and the electrode usually uses a metal material. For the enhanced-mode HEMT, a source and a drain each form conductive ohmic contact with the barrier layer, and a gate is in contact with the barrier layer through a gate semiconductor (a p-type cap layer, p-Cap, for example, a p-GaN layer). A dashed line in the channel layer represents two-dimensional electron gas (two-dimensional electron gas, 2DEG) generated in a heterostructure formed by the channel layer and the barrier layer in the HEMT. The two-dimensional electron gas in a plane direction (for example, a dashed line in the channel layer in FIG. 12A) has a very high mobility, and is a basis for working of the HEMT. In some examples, the HEMT further includes a source field plate (s-field plate, s-FP) that is fabricated on a source s and that is formed by metal, and a drain field plate (d-field plate, d-FP) that is fabricated on a drain d and that is formed by metal. The s-FP and the d-FP may improve an edge electric field of the device, and play a role in increasing a breakdown voltage. Certainly, the s-FP and the d-FP are optional structures in the HEMT. FIG. 12B provides a cell structure of a depletion-mode HEMT. Different from the enhanced-mode HEMT, in the depletion-mode HEMT, a p-Cap facing a gate is removed, and no extra process step is added in process implementation. The Q11 and the Q12 may use a same cell structure as the Q1. To be specific, the Q11, the Q12, and the Q1 are a same enhanced-mode HEMT or a same depletion-mode HEMT. Usually, in the field of semiconductor devices, each switching transistor is usually formed by connecting several cell structures in parallel. A layout, a geometric shape, and a size of the cell structure, a cell density, and a chip area of the switching transistor determine a turn-on voltage drop, and the turn-on voltage drop is an important parameter that affects an output power of a device. If a width of a direction in which a gate of the HEMT extends between a source and a drain is defined as a gate width WG (a total gate width of the cell structure), a gate width of the Q1 is denoted as WGmain, and a gate width of the Q11 and a gate width of the Q12 are denoted as WGsense. Different from the Q11 and the Q12, the Q1 has a larger current flowing capability and a lower turn-on impedance. Therefore, a value of WGmain is far greater than a value of WGsense, and 10≤WGmain:WGsense≤10000 is preferred. To implement a large gate width of the Q1, usually, the source s1, the source field plate s1-FP, the gate g1, the drain d1, and the drain field plate d1-FP of the Q1 are periodically fabricated on the epitaxial layer to form a structure of the Q1, and a plurality of HEMT cells are connected in parallel to implement a larger current flowing capability and a lower turn-on impedance of the Q1. Refer to FIG. 13A and FIG. 14A. FIG. 13A is a diagram of a cross-sectional structure of the chip in Example 1, and FIG. 14A is a diagram of a top-view structure of the chip in Example 1. FIG. 13A mainly shows electrical connection relationships between electrodes of the Q1, the Q11, and the Q12, and the PADs. The Q11 and the Q12 shown in FIG. 13A and FIG. 14A are connected in parallel. FIG. 14A is a diagram of an interconnection structure solution based on the cross-sectional structure in FIG. 13A. Usually, the source s1, the source field plate s1-FP, the gate g1, the drain d1, and the drain field plate d1-FP of the Q1 are periodically fabricated on the channel layer of the substrate through underlying metal to form a structure of the Q1. The substrate is divided into two regions: a first region and a second region. The source s11, the source field plate s11-FP, the gate g11, the drain d11, and the drain field plate d11-FP of the Q11 are fabricated on underlying metal of the first region. The source s12, the source field plate s12-FP, the gate g12, the drain d12, and the drain field plate d12-FP of the Q12 are fabricated on underlying metal of the second region. With reference to FIG. 14A, electrodes of the Q1, the Q11, and the Q12 are interconnected to the PADs (where the PAD is fabricated on top metal (top metal, TM)) through interconnection metal and a metalized via (a Via, which is also referred to as a guide hole). Refer to FIG. 13B and FIG. 14B. FIG. 13B is a diagram of a cross-sectional structure of the chip in Example 1, and FIG. 14B is a diagram of a top-view structure of the chip in Example 1. The Q11 and the Q12 in FIG. 13B and FIG. 14B are connected in series.

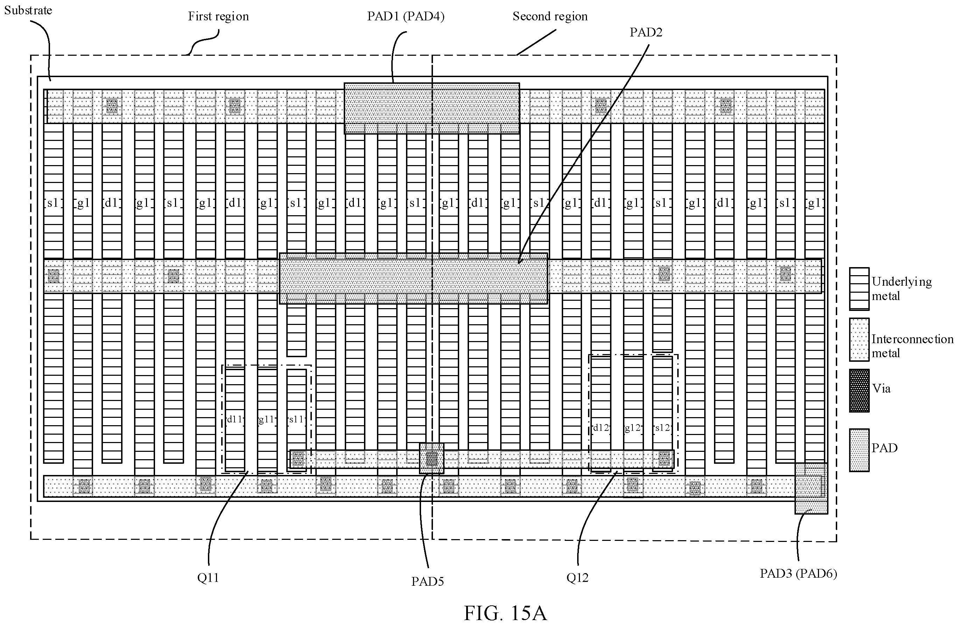

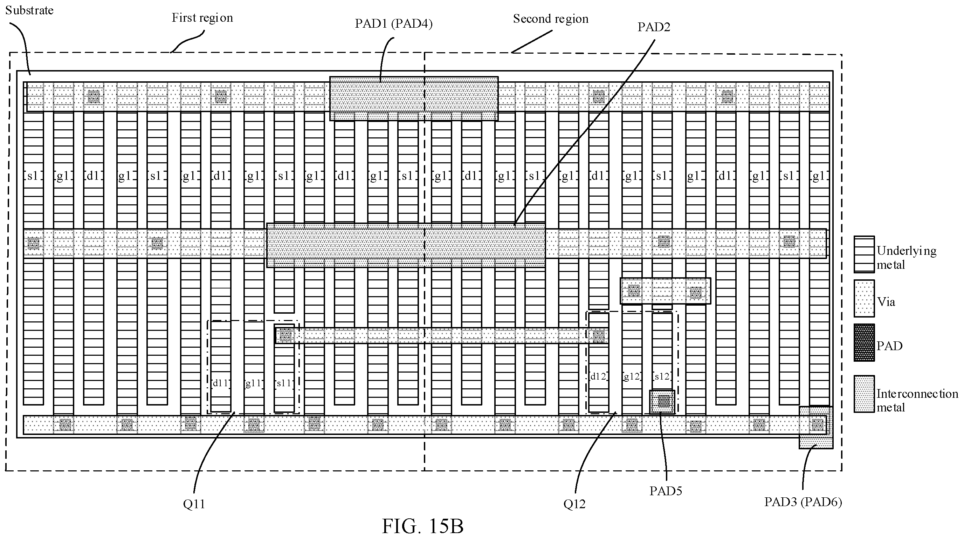

In addition, in Example 1, when the Q11 and the Q12 are connected in parallel, the drain of the Q11, the drain of the Q12, and the drain of the Q1 are all electrically connected to the undotted terminal p2 of the primary-side coil. Therefore, with reference to FIG. 15A, the drain d11 of the Q11, the drain d12 of the Q12, and the drain d1 of the Q1 may be directly electrically connected on the substrate through underlying metal, and the PAD1 and the PAD4 are shared, thereby reducing wire bonding between the chip and another device. Similarly, the gate g11 of the Q11, the gate g12 of the Q12, and the gate g1 of the Q1 may also be directly electrically connected on the substrate through underlying metal, and the PAD3 and the PAD6 are shared. Similarly, with reference to FIG. 15B, in Example 1, when the Q11 and the Q12 are connected in series, both the drain of the Q11 and the drain of the Q1 are electrically connected to the undotted terminal p2 of the primary-side coil, and the drain d11 of the Q11 and the drain d1 of the Q1 may be directly electrically connected on the substrate through underlying metal, and the PAD1 and the PAD4 are shared, thereby reducing wire bonding between the chip and another device. Similarly, the gate g11 of the Q11, the gate g12 of the Q12, and the gate g1 of the Q1 may also be directly electrically connected on the substrate through underlying metal, and the PAD3 and the PAD6 are shared. Certainly, it may be understood that the PAD is mainly used to connect to an external device of the chip through wire bonding. Therefore, the PAD may be flexibly disposed based on a connection relationship between a circuit formed by switching transistors on the chip and the external device. The foregoing is described merely by using an example in which three switching transistors: the Q1, the Q11, and the Q12 are included. When more switching transistors are disposed on the chip, or there is another connection relationship between the switching transistors and the external device, more PADs may be disposed. Therefore, only some PAD disposing examples are in the following examples of this application, and another PAD disposing manner that may be further figured out based on the examples provided in embodiments of this application should also fall within the protection scope of this application.

In the chip provided in Example 1 above, the Q11 and the Q12 are separately fabricated in different regions on the substrate, and the Q11 and the Q12 are connected in series or in parallel and then serve as equivalent switching transistors on a current sampling link. Therefore, this can avoid impact of a difference between material defects at different locations on a chip yield, thereby reducing impact of fluctuation of a turn-on resistance (or a dynamic turn-on resistance) of a switching transistor on current sampling precision. Specifically, when the Q11 and the Q12 are connected in parallel, if a turn-on resistance of the Q11 in the first region increases due to a material defect, and a turn-on resistance of the Q12 in the second region decreases due to a material defect, equivalent resistances of the Q11 and the Q12 connected in parallel may reduce fluctuation of the turn-on resistance (or the dynamic turn-on resistance), thereby reducing impact on current sampling precision. For another example, when the Q11 and the Q12 are connected in series and equivalent resistances are consistent, a resistance value of a single device connected in series needs to be further reduced. Therefore, a gate width of the Q11 and a gate width of the Q12 may be increased as much as possible, to reduce the equivalent resistance. After the gate width is increased, the switching transistor occupies a larger chip area on the substrate. Therefore, this can effectively avoid impact of a local material defect on fluctuation of the turn-on resistance (or the dynamic turn-on resistance), thereby reducing impact on current sampling precision. Certainly, it should be understood that, although the chip provided in Example 1 above is mainly described by using an example in which current sampling is applied to a high-potential end (a dotted terminal or an undotted terminal of a primary-side coil) and a low-potential end (ground) of a switching power supply, it is not limited to current sampling on the primary-side coil of the switching power supply. It should be understood that current sampling is also applicable to a path between any two of the high-potential end and the low-potential end with current sampling. However, when current sampling of the primary-side coil is applied, current sampling precision of the primary-side coil can be improved.

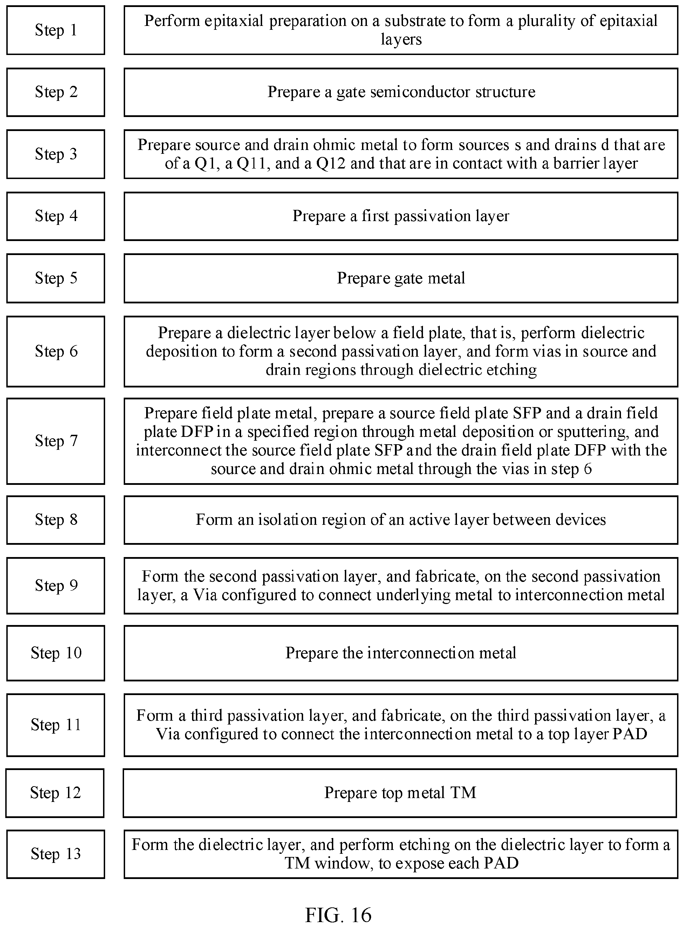

In Example 1, a method for fabricating the chip 30 is further provided. With reference to FIG. 16, the method includes the following steps.

Step 1: Perform epitaxial preparation on a substrate to form a plurality of epitaxial layers.

For example, the substrate may be Si, SiC, sapphire, or the like. The plurality of epitaxial layers include a nucleation layer (nucleation layer), a buffer layer (buffer layer), a channel layer (channel layer), a barrier layer (barrier layer), and a p-Cap material layer.

A method for forming the nucleation layer may be, for example, a metal-organic chemical vapor deposition (metal-organic chemical vapor deposition, MOCVD) growth method or a molecular beam epitaxy (molecular beam epitaxy, MBE) growth method. A material of the nucleation layer may include, for example, one or more of GaN, AlGaN (aluminum gallium nitride), and AlN (aluminum nitride). The nucleation layer is configured to provide a nucleation center and promote epitaxial growth of the buffer layer.

A method for forming the buffer layer may be, for example, using an MOCVD process to epitaxially grow an AlGaN gradient layer whose Al (aluminum) composition gradually decreases. For example, an Al_{0.8}Ga_{0.2}N layer, an Al_{0.5}Ga_{0.5}N layer, an Al_{0.2}Ga_{0.8}N layer, and a GaN layer are sequentially formed on the nucleation layer by using the MOCVD process, to form the buffer layer.

A method for forming the channel layer may be, for example, an MOCVD growth method or an MBE growth method. A material of the channel layer may include, for example, one or more of GaN, InGaN, InAlN (indium aluminum nitride), and ScAlN (scandium aluminum nitride).

A method for forming the barrier layer may be, for example, an MOCVD growth method or an MBE growth method. A material of the barrier layer may include, for example, one or more of AlGaN, InAlN, AlN, ScAlN, and InAlGaN. Materials of the channel layer and the barrier layer are different. For example, the material of the channel layer includes GaN, and the material of the barrier layer includes AlGaN.

A method for forming the p-Cap material layer may be, for example, an MOCVD growth method or an MBE growth method. A material of the p-Cap material layer may be, for example, p-GaN or p-AlGaN.

Step 2: Prepare a gate semiconductor structure.

The gate semiconductor structure, namely, the p-Cap in FIG. 12A, is formed by removing a p-Cap material layer outside gate regions of a Q1, a Q11, and a Q12 through an etching process.

Step 3: Prepare source and drain ohmic metal to form sources s and drains d that are of the Q1, the Q11, and the Q12 and that are in contact with the barrier layer.

For example, the source and drain ohmic metal may be formed through a patterning process (including steps such as film formation and photolithography). First, source and drain metal layers are formed through metal deposition or sputtering; and then source s structures and drain d structures that are of the Q1, the Q11, and the Q12 and that are in contact with the barrier layer are formed through photolithography, and ohmic contact is formed through an annealing process.

A material of the source and drain metal layers may be, for example, a titanium (Ti) layer, an Al layer, a nickel (Ni) layer, and a gold (Au) layer that are sequentially stacked, that is, the source and drain metal layers are Ti/Al/Ni/Au. Alternatively, a material of the source and drain metal layers may be a Ti layer, an Al layer, a Ti layer, and an Au layer that are sequentially stacked, that is, the source and drain metal layers are Ti/Al/Ti/Au. Alternatively, a material of the source and drain metal layers may be a Ti layer, an Al layer, and a tin (TiN) layer that are sequentially stacked, that is, the source and drain metal layers are Ti/Al/TiN. Alternatively, a material of the source and drain metal layers may be a tantalum (Ta) layer, an Al layer, and a TiN layer that are sequentially stacked, that is, the source and drain metal layers are Ta/Al/TiN. Alternatively, a material of the source and drain metal layers may be a Ta layer, an Al layer, and a Ta layer that are sequentially stacked, that is, the source and drain metal layers are Ta/Al/Ta.

Step 4: Prepare a first passivation layer.

The first passivation layer is formed through dielectric deposition at the AlGaN barrier layer and on a p-Cap surface, and may be any insulation dielectric such as aluminum nitride, silicon nitride, or silicon oxide. In addition, a source window, a drain window, and a gate window are formed through dielectric etching in source, drain, and gate regions.

Step 5: Prepare gate metal.

At the gate window, gate metal is formed through a metal deposition or sputtering and annealing process to be in contact with a semiconductor.

A material of the gate metal may be, for example, Ti, TiN, Ni, or palladium (Pd).

Step 6: Prepare a dielectric layer below a field plate, that is, perform dielectric deposition to form a second passivation layer, and form vias in the source and drain regions through dielectric etching.

Step 7: Prepare field plate metal, prepare a source field plate SFP and a drain field plate DFP in a specified region through metal deposition or sputtering, and interconnect the source field plate SFP and the drain field plate DFP with the source and drain ohmic metal through the vias in step 6.

Step 8: Form an isolation region of an active layer between devices.

Isolation regions between different regions may be formed through ion implantation or GaN etching and insulation layer deposition (with reference to FIG. 13A and FIG. 13B), to avoid signal crosstalk. The isolation region may be formed, for example, through an implantation process or an etching process, to implement electronic blocking effect between different functional devices.

Step 9: Form the second passivation layer, and fabricate, on the second passivation layer, a Via configured to connect underlying metal to interconnection metal.

On a surface of the device formed in step 8, the second passivation layer is formed through dielectric deposition, and may be any insulation dielectric such as aluminum nitride, silicon nitride, or silicon oxide. Then, a via is etched through one patterning process at a location at which the interconnection metal is fabricated, and metal is deposited in the via to form a Via.

Step 10: Prepare the interconnection metal.

With reference to FIG. 14A, an interconnection metal layer may be deposited on the second passivation layer, and then interconnection metal of a specific shape is formed through a patterning process. The interconnection metal may interconnect all d1 of the Q1, or interconnect all s1 of the Q1, and interconnect a d11 with a d12, a g11 with a g12, and an s11 with an s12.

Step 11: Form a third passivation layer, and fabricate, on the third passivation layer, a Via configured to connect the interconnection metal to a top layer PAD.

Step 12: Prepare top metal (top metal, TM).

With reference to FIG. 14A, a layer of top metal may be deposited on the third passivation layer, and then top layer PADs of a specific shape are formed through a pattering process. These top layer PADs may be the PAD1 to the PAD6 that are connected to the interconnection metal layer through the via formed in step 11.

Step 13: Form the dielectric layer, and perform etching on the dielectric layer to form a TM window, to expose each PAD.

The chip provided in Example 1 is formed by performing Step 1 to Step 13 above. Certainly, the steps above are merely an example of a fabricating process. In some examples, some processes may be added, deleted, or changed based on the steps above to make structural optimization or improvement. For example, the steps above are mainly described by using an example in which the enhanced-mode HEMT is fabricated to implement the Q1, the Q11, and the Q12. When the depletion-mode HEMT is used to implement the Q1, the Q11, and the Q12, a p-Cap fabricating process needs to be omitted.

### Example 2:

In some examples, for ease of description, a plurality of switching transistors used in a current sampling link may be divided into n auxiliary units, and each auxiliary unit includes a switching transistors. For example, a value of n may range from 1 to 10, and a value of a may range from 1 to 10. It should be noted that values of n and a cannot be 1 at the same time. To be specific, more than two auxiliary units may be disposed on the current sampling link, and at least one switching transistor is disposed in each auxiliary unit. Alternatively, it may be considered that, when only one auxiliary unit is disposed on the current sampling link, the auxiliary unit includes at least two or more switching transistors. The a (a≥2) switching transistors in each auxiliary unit may be evenly distributed in a regions on a substrate. The a regions may be a plurality of equal partition regions with a same area on the substrate. For example, the equal partition regions may be equal to a quantity of switching transistors on the current sampling link. For example, as shown in FIG. 14A, the substrate may be equally partitioned into two regions: a first equal partition region and a second equal partition region. The first region is the first equal partition region, and the second region is the second equal partition region. A Q 11 and a Q12 are fabricated at an epitaxial layer on the substrate. Therefore, turn-on impedances of the Q11 and the Q12 depend on material characteristic parameters of the epitaxial layer. However, material characteristic parameters of the epitaxial layer at different locations on the substrate are randomly distributed. For ensuring that equivalent impedances of the Q11 and the Q12 or more switching transistors connected in series or in parallel can effectively avoid impact of a local material defect on fluctuation of a turn-on resistance (or a dynamic turn-on resistance), the substrate may be equally partitioned into a plurality of equal partition regions, and switching transistors used on the current sampling link are evenly distributed in the equal partition regions.

In addition, the Q11 and the Q12 are fabricated at the epitaxial layer on the substrate, and both a material characteristic parameter of the epitaxial layer in the first region and a material characteristic parameter of the epitaxial layer in the second region fall within a predetermined range. The Q11 and the Q12 are fabricated at the epitaxial layer on the substrate. Therefore, the turn-on impedances of the Q11 and the Q12 depend on material characteristic parameters of the epitaxial layer. However, material characteristic parameters of the epitaxial layer at different locations on the substrate are randomly distributed. For ensuring that equivalent impedances of the Q11 and the Q12 or more switching transistors connected in series or in parallel can effectively avoid impact of the local material defect on fluctuation of the turn-on resistance (or the dynamic turn-on resistance), the Q11 and the Q12 may be separately fabricated in the first region and the second region in which the material characteristic parameters are close as much as possible. For example, the material characteristic parameter may be measured by a defect density per unit area. The defect may be a material defect at the epitaxial layer or a defect caused by a fabricating process on a device. In addition, for ensuring that equivalent impedances of the Q11 and the Q12 or more switching transistors connected in series or in parallel can effectively avoid impact of the local material defect on fluctuation of the turn-on resistance (or the dynamic turn-on resistance), the Q11 and the Q12 may be separately fabricated in a region in which the material characteristic parameters are close as much as possible. For example, an impedance difference between the Q11 and the Q12 that are fabricated and formed may be less than a preset proportion, for example, less than 5%. Alternatively, a ratio of an average impedance of the Q11 and the Q12 to an impedance of the Q1 ranges from 10:1 to 1000: 1. In this way, a current sampling range is guaranteed when a chip area is not affected. In addition, an impedance ratio cannot be excessively large, to ensure that areas occupied by the second switching transistor and the third switching transistor on the substrate are not excessively small, and ensure current sampling precision.

In addition, with reference to the cell structures shown in FIG. 12A and FIG. 12B, the Q11, the Q12, and a Q1 have a consistent cell structure, and the Q11 and the Q12 occupy a same area on the substrate. When the Q11 and the Q12 have the same cell structure and occupy the same area, impedance uniformity is relatively high, further improving current sampling precision.

In addition, a connection relationship between each auxiliary unit and switching transistors in the auxiliary unit is not limited in embodiments of this application. For example, the auxiliary units may be connected in series or in parallel, and the switching transistors in the auxiliary unit may also be connected in series or in parallel. In addition, in embodiments of this application, a quantity of auxiliary units connected on the current sampling link is not limited. For example, for meeting requirements of different PWM _ICs for current sampling precision, k (where 0<k≤n, and k is an integer) auxiliary units may be disposed on the current sampling link. A value of k is selected, so that a value of an equivalent turn-on resistance of the switching transistor on the current sampling link may be adjusted to further adjust a value of a sampled current flowing through a Rsen, to be compatible with PWM_ICs with different precision and ranges.

A specific example is described as follows:

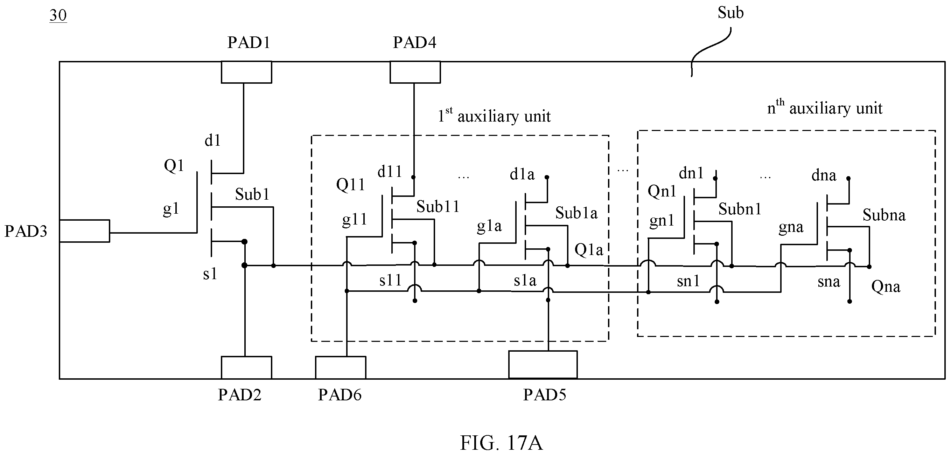

FIG. 17A is a schematic of a circuit topology of a chip. The chip includes: a substrate Sub, a switching transistor Q1 fabricated on the substrate Sub, and n auxiliary units (a 1^{st} auxiliary unit 1, ..., and an n^{th} auxiliary unit, where n≥1).

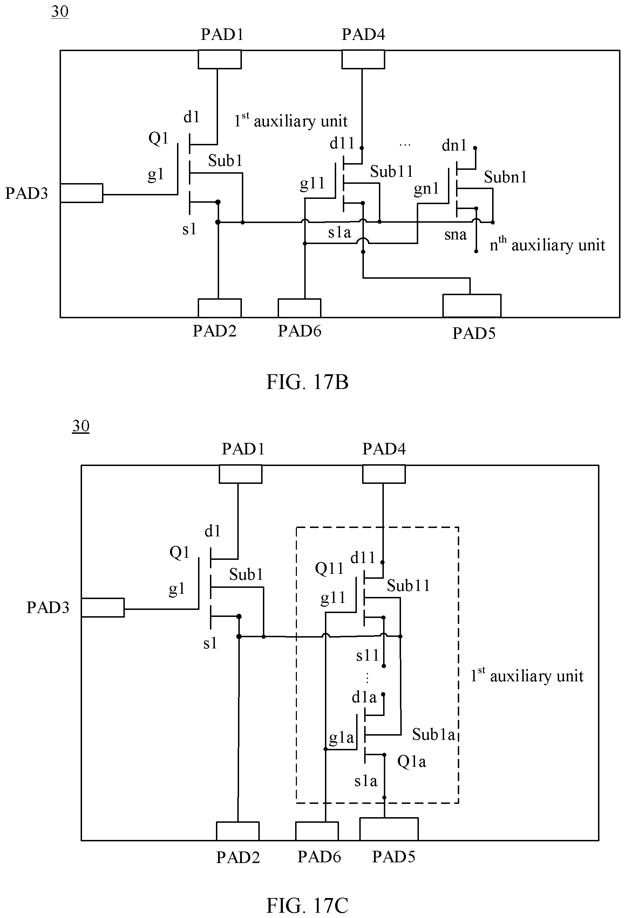

As a power-stage switching transistor, the Q1 includes a gate g1, a source s1, a drain d1, and a substrate electrode Sub1. Between the d1 to the s1, most of current signals on a power current link are transmitted for conduction. The current sampling link includes n auxiliary units (n≥1), and each auxiliary unit includes a HEMTs that are cascaded. An i^{th} HEMT (1≤i≤a) Qji of a j^{th} auxiliary unit (1≤j≤n, a≥2) includes a source sji, a drain dji, a gate gji, and a substrate electrode Subji. In addition, with reference to FIG. 17B, in the description of the example below, a drain dj1, a gate gj1, and a substrate electrode Subj1 of a 1^{st} HEMT Qj1 of the j^{th} auxiliary unit are denoted as an equivalent auxiliary drain dj1, an equivalent auxiliary gate gj1, and an equivalent auxiliary substrate electrode Subj1 of the j^{th} auxiliary unit; and a source sja of an a^{th} HEMT Qja of the j^{th} auxiliary unit is denoted as an equivalent auxiliary source sja of the j^{th} auxiliary unit. Moreover, the Q1 and n*a HEMTs are on a same substrate. To be specific, substrate electrodes Sub1 and Sub11 to Subna may be a same electrode or at least electrically interconnected, and a HEMTs of a single auxiliary unit are distributed in a different regions of the same substrate. In this way, fluctuation of a ratio of an equivalent turn-on resistance of a switching transistor in the current sampling link to a turn-on resistance of the Q1 due to a difference of material defects is reduced as much as possible, and current sampling precision is improved. On the current sampling link, a drain d11 of a 1^{st} HEMT Q11 of at least a 1^{st} auxiliary unit is electrically interconnected with the drain d1 of the Q1 and then connected to a PDA4 (or interconnected with the drain d1 of the Q1 and then connected to a PAD1), and the remaining n*a-1 HEMTs are cascaded with the Q1 in any manner of serial connection, parallel connection, or a combination of serial and parallel connection. In an example, an equivalent auxiliary source s1a of the 1^{st} auxiliary unit is connected to a PAD5, and an equivalent auxiliary gate g1a of the 1^{st} auxiliary unit is connected to a PAD6 (or connected to a PAD3 together with the gate g1 of the Q1). The current sampling link is used to shunt a current (ISEN), conduct the current to the resistor Rsen shown in FIG. 7, and output a sampled signal to a PWM_IC to perform current monitoring and detection of the circuit. Certainly, in another example, another auxiliary unit may also be cascaded on the current sampling link. For example, an equivalent auxiliary drain sia of each auxiliary unit may be connected to one PAD, and is connected to the resistor Rsen through the PAD.

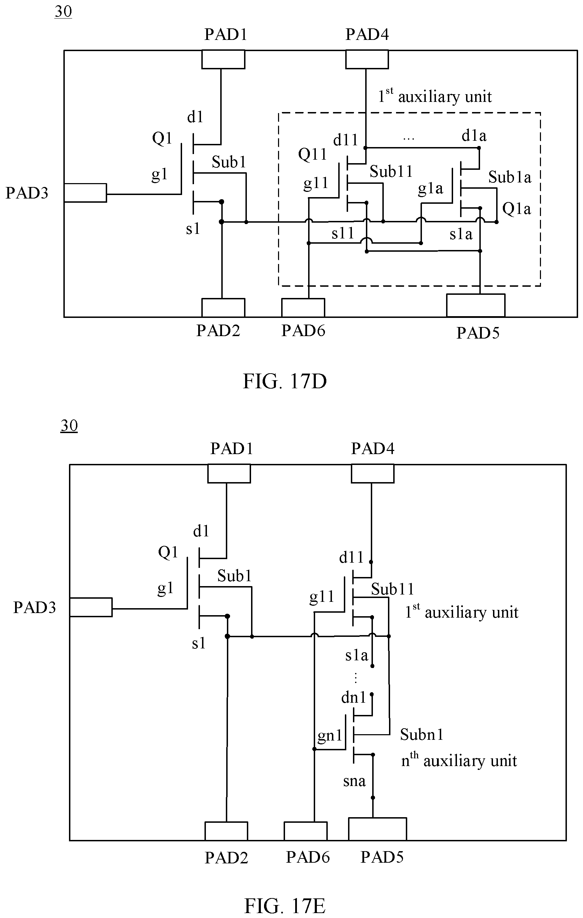

With reference to the solution shown in FIG. 17C, an example in which the current sampling link includes one auxiliary unit (including a HEMTs) is used. The a HEMTs in the current sampling link are connected in series, gates (a g11 to a g1a) of the a HEMTs are electrically connected, and substrate electrodes Sub11 to Sub1a are still electrically connected to a Sub1. A drain d11 of a 1^{st} HEMT Q11 in the a HEMTs is electrically connected to a drain d1 of a Q1 and then connected to a PAD4 (or connected to a PAD1 together with a drain d1 of the Q1), a source s11 of a Q11 is connected to a drain d12 of a 2^{nd} HEMT Q12, and so on, until a source s1(a-1) of an (a-1)^{th} HEMT Q1(a-1) is electrically connected to a drain d1a of an a^{th} HEMT Q1a, and a source s1a of the a^{th} HEMT Q1a is connected to a PAD5 and is led out, and is connected to the resistor Rsen shown in FIG. 7. The Rsen may be an external independent resistor shown in FIG. 7, or the Rsen may be a resistor (for example, a metal interconnection line is used as the Rsen) integrated on a same substrate of an HEMT. In the solution shown in FIG. 17D, a HEMTs in the current sampling link are connected in parallel, gates g11 to g1a of the a HEMTs (a Q11 to a Q1a) are electrically connected and then connected to a PAD6 (or connected to a PAD3 together with a gate g1 of a Q1), and substrate electrodes Sub11 to Sub1a are still electrically connected to a Sub1. After being interconnected, drains d11 to d1a are electrically connected to a d1 and then connected to a PAD4 (or connected to a PAD1 together with a drain d1 of the Q1). Sources s11 to s1a are interconnected and then connected to a PAD5 and are led out, and are electrically connected to one end of a resistor Rsen.

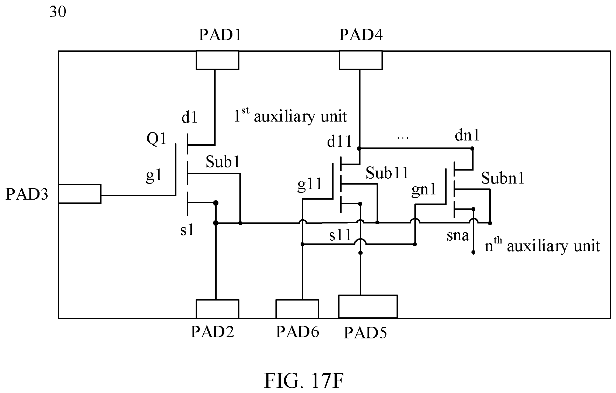

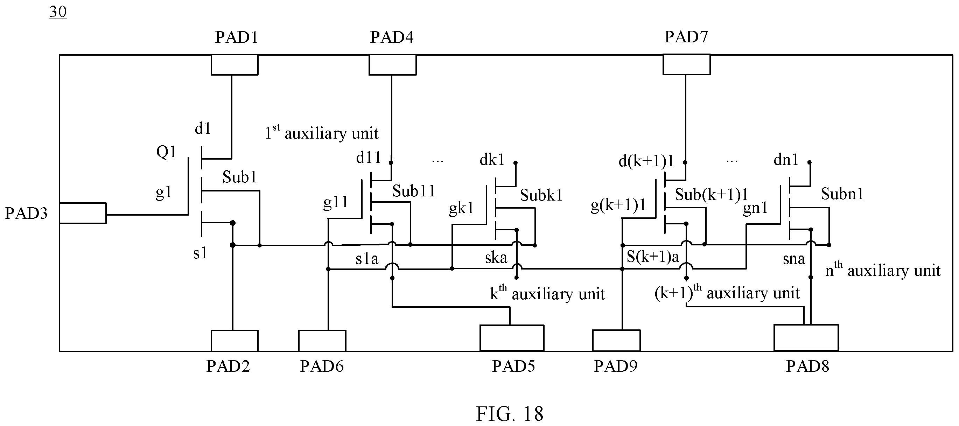

FIG. 17E shows n auxiliary units cascaded in series, and FIG. 17F shows n auxiliary units cascaded in parallel. Based on the description, to be compatible with PWM_ICs of different precision and ranges, an equivalent auxiliary drain dj1 (1≤j≤n) of each auxiliary unit may be connected to one PAD and separately led out, and an equivalent auxiliary source sja (1≤j≤n) of each auxiliary unit may be connected to one PAD and separately led out, so that k auxiliary units are selectively interconnected with a CS node, thereby adjusting a value of an equivalent turn-on resistance of a switching transistor on the current sampling link. Certainly, when the k auxiliary units are interconnected with the CS node, the k auxiliary units may be connected in series or in parallel to the CS node through wire bonding between PADs. For example, all PADs of equivalent auxiliary drains dj1 of the k auxiliary units may be connected to a PAD1 of a Q1 through wire bonding, and all PADs of equivalent auxiliary sources sja of the k auxiliary units may be connected to the CS node through wire bonding, so that the k auxiliary units are connected in parallel to the CS node. Alternatively, a PAD of an equivalent auxiliary drain d11 of a 1^{st} auxiliary unit may be connected to a PAD1 of a Q1 through wire bonding, a PAD of an equivalent auxiliary source s1a of the 1^{st} auxiliary unit is connected to a PAD of an equivalent auxiliary drain d21 of a 2^{nd} auxiliary unit through wire bonding, a PAD of an equivalent auxiliary source s2a of the 2^{nd} auxiliary unit is connected to a PAD of an equivalent auxiliary drain d31 of a 3^{rd} auxiliary unit through wire bonding, ...., and a PAD of an equivalent auxiliary source sja of a k^{th} auxiliary unit is connected to the CS node through wire bonding, so that the k auxiliary units are connected in series to the CS node. In addition, to avoid waste of the remaining n-k auxiliary units, with reference to FIG. 18, equivalent sources sja of the remaining n-k auxiliary units may also be interconnected with the source s1 of the Q1, so that the remaining n-k auxiliary units are connected in parallel to the Q1 as a part of a power current link. As shown in FIG. 18, an example is provided as follows: The remaining n-k auxiliary units may be connected in parallel between a PAD7 and a PAD8. The PAD7 and the PAD1 may be connected externally through wire bonding, the PAD8 and the PAD2 may be connected externally through wire bonding, and a PAD9 and a PAD3 may be connected externally through wire bonding or gates of switching transistors are electrically connected directly on a chip through interconnection metal.

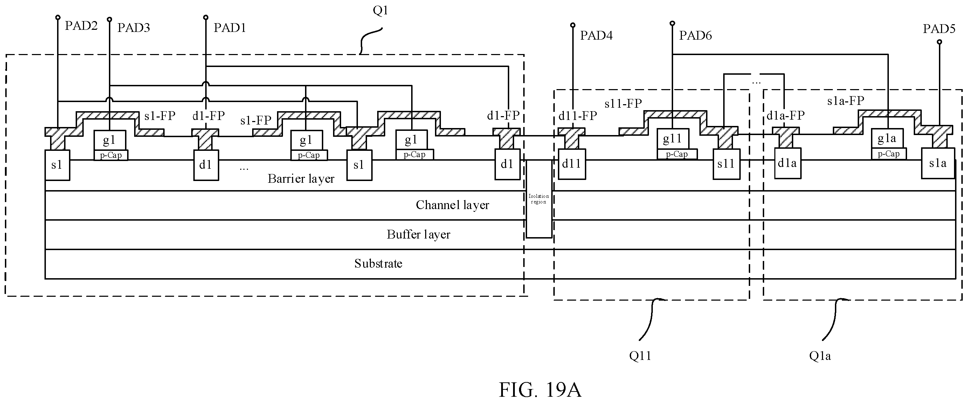

FIG. 19A is a diagram of a cross-sectional structure of the chip in FIG. 17C in Example 2. A plurality of HEMT devices in a single auxiliary unit are connected in series. An example in which a Q1 and a Qj1 to a Qja all use an enhanced-mode HEMT structure in which p-Cap is a gate semiconductor is used. From bottom to top, the structure includes a substrate Sub; an epitaxial layer above the substrate Sub, including a buffer layer, a channel layer, a barrier layer, and a local p-Cap as a gate semiconductor layer; and a passivation insulation layer disposed above the epitaxial layer, a Q1 including a source s1, a source field plate s1-FP, a gate g1, a drain d1, and a drain field plate d1-FP that are periodically arranged, and an i^{th} HEMT Qji (1≤j≤n, 1≤i≤a) that is of a j^{th} auxiliary unit and that includes a source sji, a source field plate sji-FP, a gate gji, a drain dji, and a drain field plate dji-FP. A cell structure of the Qji is consistent with a cell structure of the Q1. In FIG. 19A, an example in which a Q11 to a Q1a in a 1^{st} auxiliary unit are connected in series is used. A drain d11 of the Q11 and the drain d1 of the Q1 are interconnected and then connected to a PAD1 (or a drain d11 of the Q11 is connected to a PAD4, and a PAD1 and the PAD4 are connected externally through wire boding), and a source s1i of a Q1i is interconnected with a drain d1(i+1) of a Q1(i+1) to form the 1^{st} auxiliary unit that uses a series connection solution.

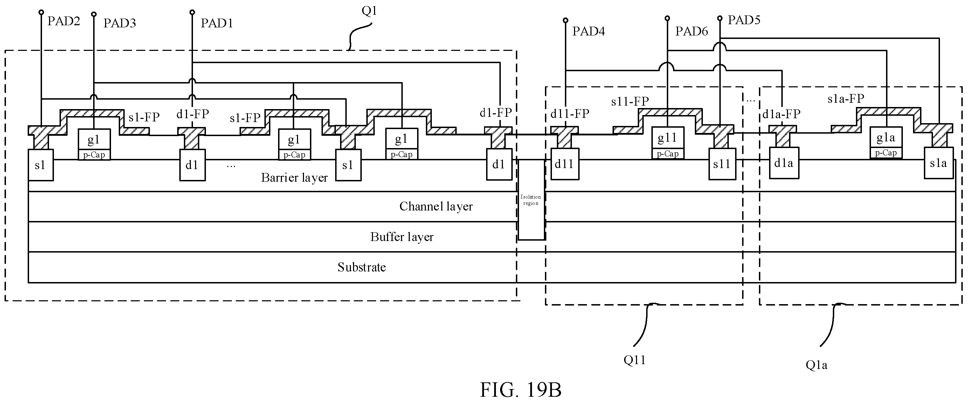

FIG. 19B is a diagram of a cross-sectional structure of the chip in FIG. 17D in Example 2. Sources (an s11 to an s1a) and drains (a d11 to a d1a) of HEMTs in a 1^{st} auxiliary unit are also interconnected to form a 1^{st} auxiliary unit that uses a parallel connection solution.

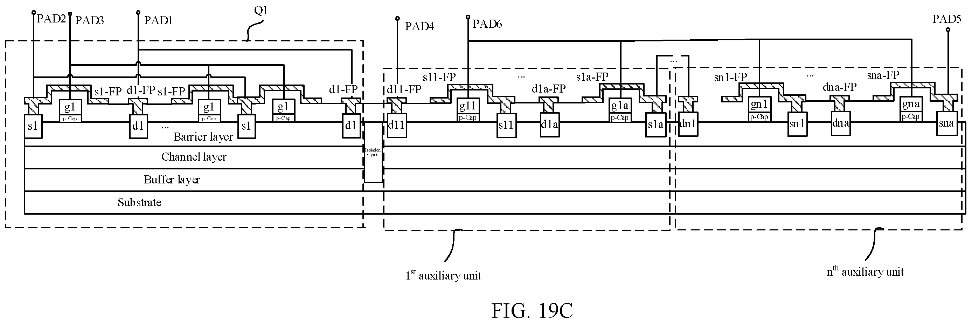

FIG. 19C is a diagram of a cross-sectional structure of the chip in FIG. 17E in Example 2. A plurality of HEMTs in each auxiliary unit may use a structure of the 1^{st} auxiliary unit shown in FIG. 17C. Then, an equivalent source sja of a j^{th} auxiliary unit may be interconnected with a drain d(j+1)1 of a (j+1)^{th} auxiliary unit, and a source sna of a Qna is connected to a PAD5 to form an auxiliary unit that uses a series connection solution.

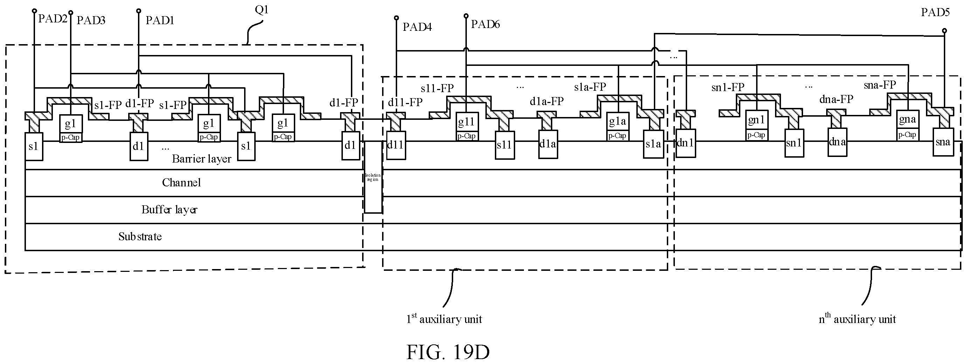

FIG. 19D is a diagram of a cross-sectional structure of the chip in FIG. 17F in Example 2. Among auxiliary units, equivalent drains dj1 are interconnected, and equivalent sources sj1 may be interconnected, and PADs may be separately led out, to form the auxiliary units that use a parallel connection solution. As shown in FIG. 19D, among auxiliary units, equivalent drains dj1 are interconnected to a PAD4, and equivalent sources sj1 are interconnected to a PAD5.

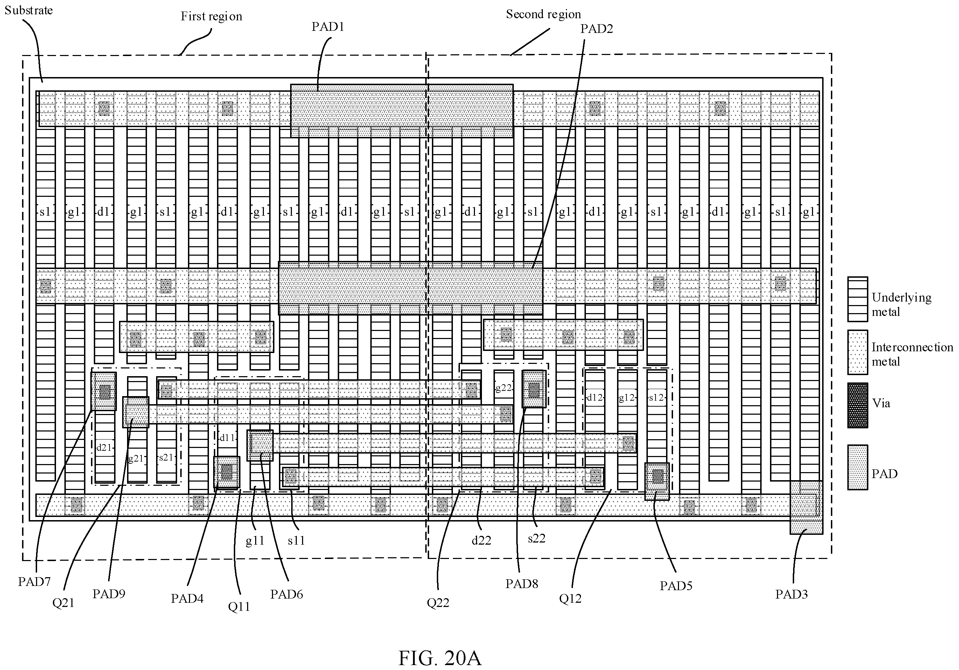

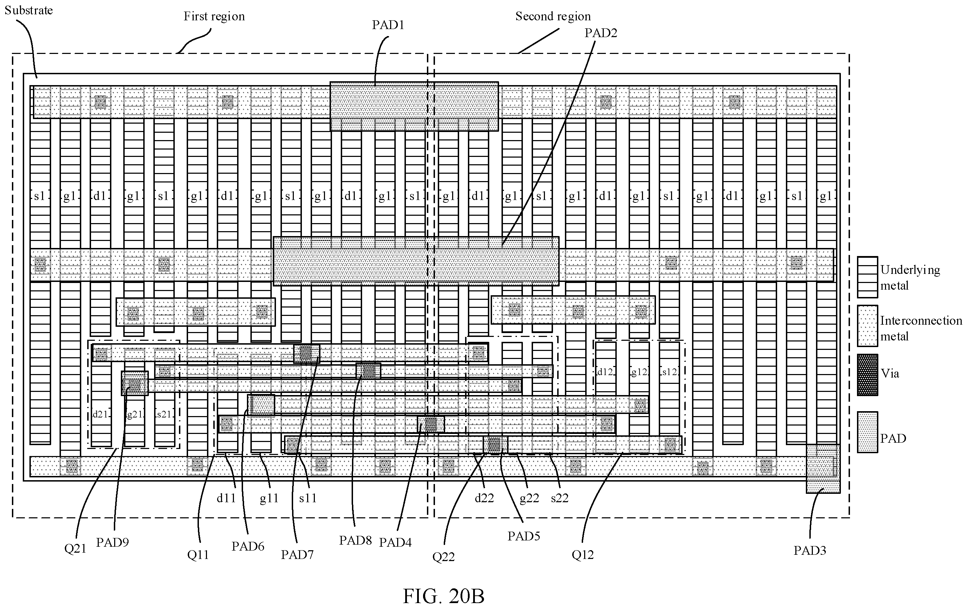

FIG. 20A and FIG. 20B each are a diagram of a top-view structure of the chip. Two auxiliary units are used as an example. A 1^{st} auxiliary unit includes a Q11 and a Q12, and a 2^{nd} auxiliary unit includes a Q21 and a Q22. A substrate is partitioned into two regions, where the Q11 and the Q21 are correspondingly disposed in a first region, and the Q12 and the Q22 are correspondingly disposed in a second region. In the top-view structural diagrams shown in FIG. 20A and FIG. 20B, it is specifically shown that at least underlying metal (used as electrodes (a source, a drain, and a gate) or field plates (a source field plate and a drain field plate) for metal-semiconductor contact), a Via (used for interconnection of different layers of metal), interconnection metal (used for propagation and interconnection between underlying metal signals in different regions), and TM top metal (used to interconnect a PAD with another device (such as a PWM_IC or a Rsen)) are disposed on a substrate material (including the substrate and an epitaxial layer)

Specifically, in FIG. 19A, most regions of the chip are formed by a source, a drain, and a gate (an s1\a d1\a g1) that are included in a Q1, to ensure that a device has a relatively small turn-on impedance. In addition, HEMTs (the Q11, the Q12, the Q21, and the Q22 in dashed line boxes) of auxiliary units are disposed in at least two or more regions, and gates, drains, and sources of HEMTs in different regions are connected through Vias and interconnection metal. A Q11 and a Q12 in a 1^{st} auxiliary unit are connected in series to form an equivalent gate g11 and an equivalent source s12 of the 1^{st} auxiliary unit, and an equivalent drain d11 of the 1^{st} auxiliary unit is electrically interconnected with a drain d1 of the Q1. A Q21 and a Q22 in a 2^{nd} auxiliary unit are connected in series to form an equivalent gate g21 and an equivalent source s22 of the 2^{nd} auxiliary unit, and an equivalent drain d21 of the 2^{nd} auxiliary unit is electrically interconnected with the drain d1 of the Q1 (certainly, the d11 and the d21 may alternatively be separately connected to separate PADs and connected to a PAD1 through external wire bonding). The g11 and the g21 may be connected to separate PADs, or all of them are connected to a PAD3. In an example, a g11 is connected to a PAD6, and a g21 is connected to a PAD9, or a PAD6 and a PAD9 may be shared. For example, both the g11 and the g21 are connected to the PAD6 (PAD9). An s12 and an s22 may be connected to separate PADs, or all of them are connected to a PAD2 (PAD5). Certainly, to implement compatibility with PWM_ICs of different precision and ranges, for example, the s12 may be connected to the PAD5 and led out and is electrically connected to one end of a resistor Rsen; and the s22 is connected to a PAD8 and led out and is interconnected with a PAD1 of the source s1 of the Q1. In this solution, HEMTs are arranged in a plurality of regions and interconnected in series, and a gate width of each HEMT is appropriately increased (that is, compared with a single HEMT solution in which a gate width is WGsense and a turn-on impedance is RCS). When each auxiliary unit uses a solution of a HEMTs, a gate width of each HEMT is a*WGsense, and a turn-on impedance is RCS/a. In this way, a size of each HEMT is increased to improve an impudence process and a material defect fluctuation capability. That is, a cascading manner in the multi-region solution can further reduce relatively large fluctuation of the turn-on impedance of the HEMT due to a process and material defect fluctuation.

FIG. 19B is a diagram of a cross-sectional structure of a chip in which HEMTs in an auxiliary unit use a parallel connection solution. A greatest difference from FIG. 19A lies in that, a Q11 and a Q12 in a 1^{st} auxiliary unit are connected in parallel to form an equivalent gate g11 and an equivalent source s12 of the 1^{st} auxiliary unit, and a Q21 and a Q22 in a 2^{nd} auxiliary unit are connected in parallel to form an equivalent gate g21 and an equivalent source s22 of the 2^{nd} auxiliary unit. For a connection relationship between each electrode and a PAD, still refer to the description in FIG. 19A. Details are not described herein again.

In addition, for a fabricating process in Example 2, refer to the fabricating process provided in FIG. 16 in Example 1. Because a difference between Example 1 and Example 2 lies only in a quantity of switching transistors on a current sampling link, the fabricating processes of the two examples are totally the same, and the difference lies only in a quantity of switching transistors formed in one fabricating process.

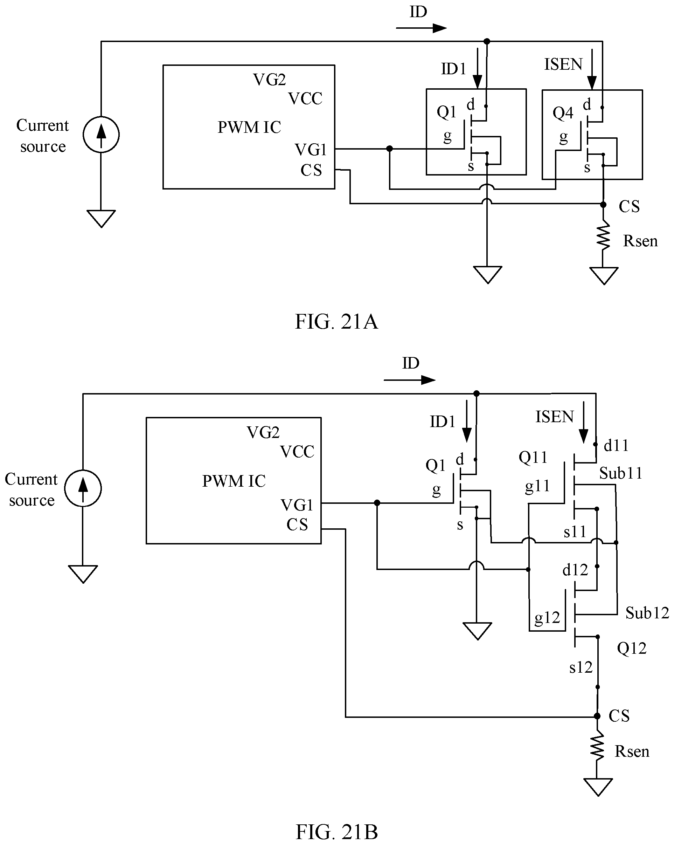

For verifying technical effects of Example 1 and Example 2 of this application, the series connection solution shown in FIG. 11A is used as an example. The technical effects of Example 1 and Example 2 are described by simulating sampled currents ISEN at different temperatures and analyzing numerical fluctuation of a turn-on impedance Rdson after connection in series and in parallel in a plurality of regions. FIG. 21A is a schematic of an equivalent circuit for simulating sampled currents according to the conventional technology shown in FIG. 6 (a single switching transistor Q4 is used on a current sampling link) by using a current source. FIG. 21B is a schematic of an equivalent circuit for simulating sampled currents according to the solution shown in FIG. 11A by using a current source. A Q1, the Q4, a Q11, and a Q12 are in a turn-on state. If voltages output by a PWM_IC to gates of the Q1, the Q4, the Q11, and the Q12 are all set to 6 V, a signal source is a current source, and an output current is an ID (a current at an overcurrent detection point is set to 5 A), a current flowing through the Q1 is an ID1, and a current flowing through a sampling resistor Rsen of the Q4 (or the Q11 and the Q12) is an ISEN (ID=ID1+ISEN). The Q1 has a gate width WGmain and an impedance Rdson≈120mohm@25°C&Vgs=6V, the Q4 in FIG. 21A has a gate width WGmain/200 and an impedance Rdson≈24 ohm@25°C&Vgs=6V, and the Q11 and the Q12 in FIG. 21B both have a gate width WGmain/100 and an impedance Rdson≈12 ohm@25°C&Vgs=6V. In addition, it is considered that a sampling resistor does not change obviously with a temperature. Therefore, a Rsen with a smaller resistance value may be used, and a value of the Rsen is 2 ohms herein.

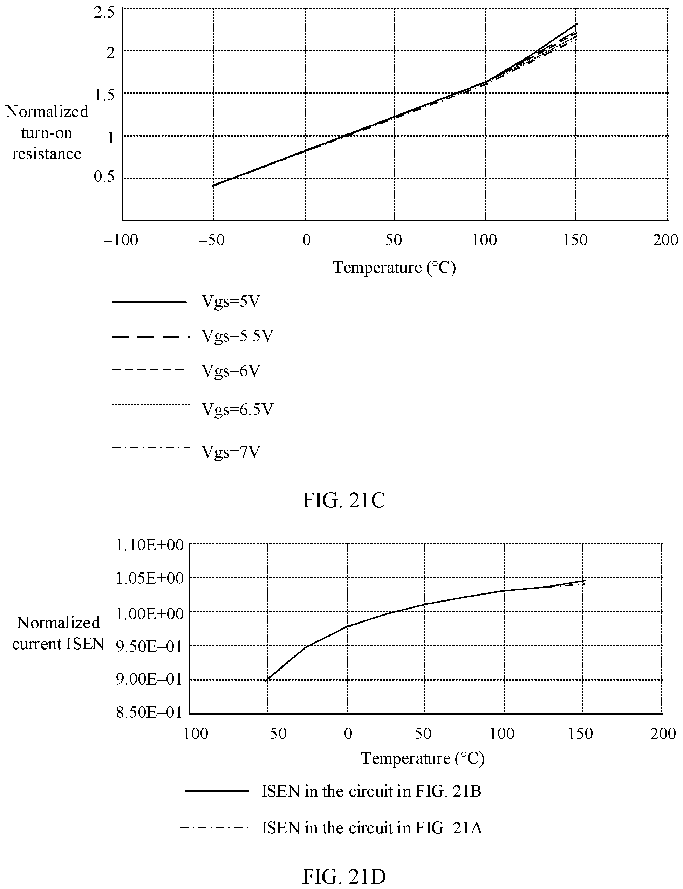

FIG. 21C shows an impedance change of an HEMT used in simulation at different temperatures and different gate voltages. It can be seen that, when a gate voltage Vgs changes from 5 V to 7 V, trends of a turn-on impedance of the HEMT with temperature degradation basically coincide. To be specific, when the gate voltage is within 5 V to 7 V, impact on the trend of the turn-on impedance (a normalized turn-on impedance (normalized Rdson)) with the temperature degradation can be basically ignored (within -50°C to 125°C). Therefore, for the HEMT on the current sampling link, whether the Vgs decrease is caused by a voltage division of the Rsen or the Vgs decrease is caused by a voltage division of another HEMT in the series connection solution may be basically ignored. FIG. 21D shows a change of sampled currents ISEN (normalized sampled currents) with different temperatures after circuit simulation. It can be seen that, compared with the current sampling link in FIG. 21A that uses a single-HEMT solution, when the current sampling link in FIG. 21B uses a multi-HEMT solution, change trends of the ISEN thereof with different temperatures basically remain unchanged. Compared with a case of 25°C, even at 150°C, a change of a detected current is also ≤5%.

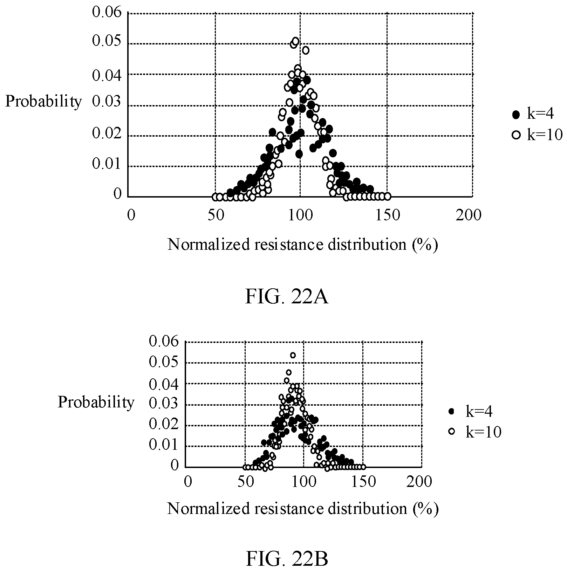

In addition, numerical analysis is performed to further evaluate impact on fluctuation of an impudence process after a multi-region HEMT cascading solution is adopted. It is assumed that a single HEMT is used on the current sampling link, and a turn-on impedance of the HEMT fluctuates randomly in a range of R0*(1±50%) (where R0 is an average value) with a process or material defect fluctuation, as shown in FIG. 9. If k HEMTs are connected in series on the current sampling link, fluctuation of an equivalent turn-on impedance is further reduced. As shown in FIG. 22A, when k=4, fluctuation of the equivalent turn-on impedance basically presents a normal distribution in a range of R0*(1±30%); and when k=10, fluctuation of the equivalent turn-on impedance basically presents a normal distribution in a range of R0*(1±20%). That is, a case in which a deviation of the turn-on impedance is relatively large may be greatly suppressed. FIG. 22B shows a distribution of equivalent impedances of k HEMTs connected in parallel on a current sampling link, which is similar to a series connection structure. In addition, it should be noted that, when the series connection solution is used, compared with a gate width in the single-HEMT solution (or a parallel connection solution) used on the current sampling link, a gate width of each device in the k HEMTs may be amplified by k times. This further reduces a chip area of the HEMT, and results in a deviation of a ratio of the turn-on impedance to a turn-on impedance of a Q1.

### Example 3:

Based on Example 1 or Example 2 above, a solution of connecting HEMTs in series may be further extended. For example, in the solution shown in FIG. 11A, FIG. 17C, or FIG. 17E, there are a plurality of HEMTs connected in series on the current sampling link. Therefore, when the plurality of HEMTs connected in series are in a cut-off state, voltage division exists, and voltages between gates g and sources s of the plurality of HEMTs are not fixed. In this case, when there is an excessively high negative voltage between gates and sources of some HEMTs, gate breakdown may occur. Therefore, in the solution provided in Example 3 in this application, a voltage clamping circuit is further properly disposed at sources of some HEMTs or between gates and sources of HEMTs, so that the voltage clamping circuit between the gates g and the sources s of the HEMTs is clamped within a proper voltage range, to avoid a gate breakdown problem caused by the excessively high negative voltage between the gates and the sources of the HEMTs.

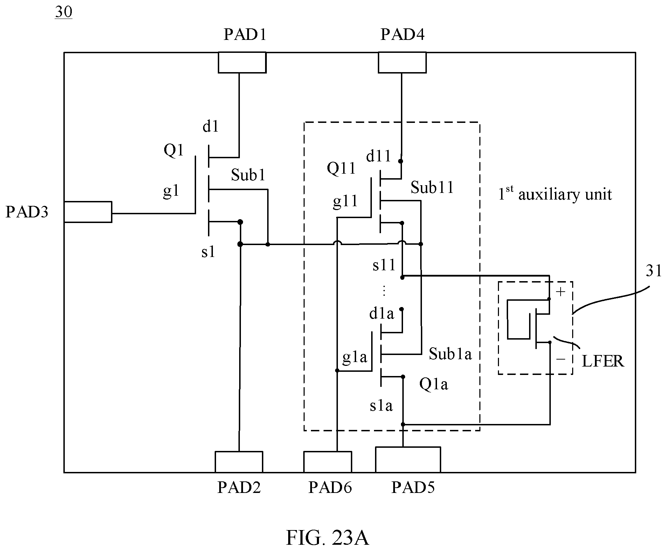

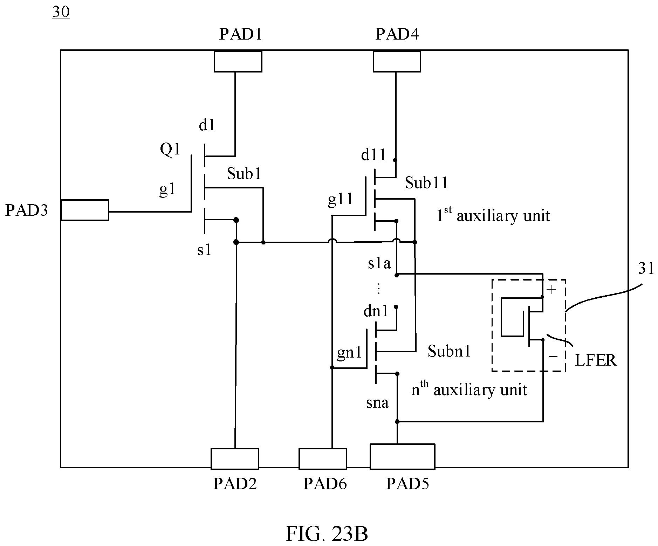

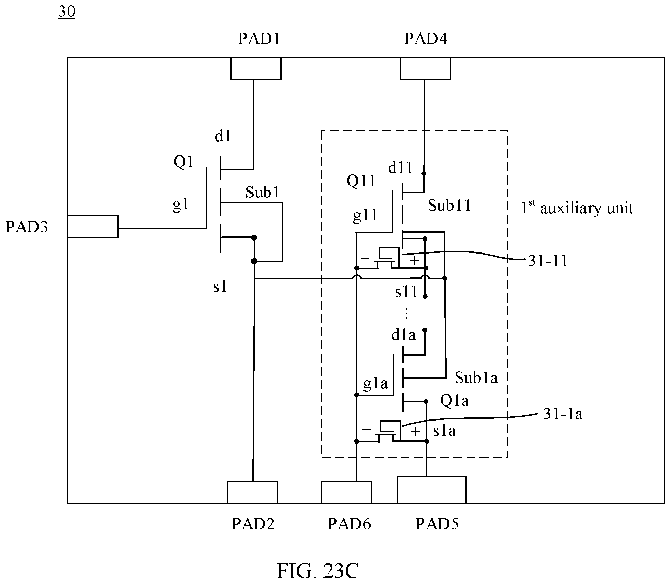

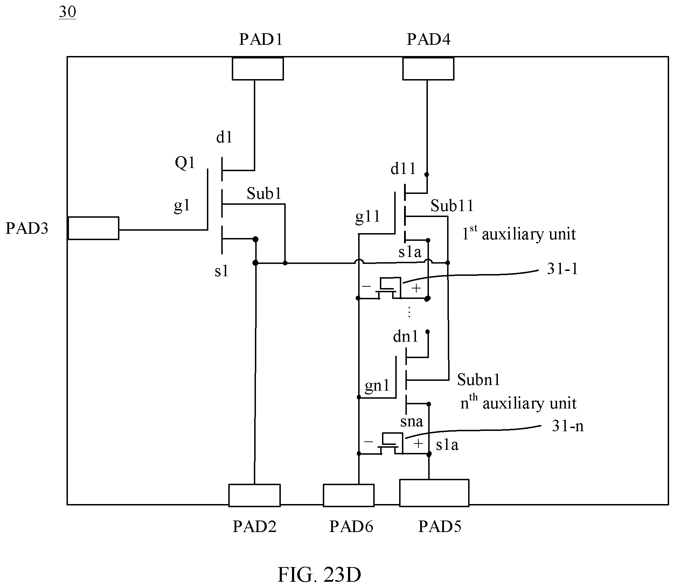

FIG. 23A is a diagram of a structure of the chip 30 in which a Q1 and a plurality of HEMTs Q11 to Q1a are integrated. The chip 30 includes the Q1 and the Q11 to the Q1a. For a specific connection relationship, refer to the description in FIG. 17C. A difference from FIG. 17C lies in that, this solution avoids a case that a negative voltage of a gate-source voltage Vg1i-s1i of an i^{th} HEMT Q1i is excessively high (Vs1i-GND)>>(Vg1i-GND) and a gate of the HEMT is broken down and burnt because there is voltage division between a drain and a source of each HEMT in the Q11 to the Q1a connected in series when the Q11 to the Q1a are in a high-voltage turn-off state. In Example 3, with reference to FIG. 23A, a voltage clamping circuit 31 may be disposed between a source s11 of the Q11 and a source s1a of the Q1a based on FIG. 17C. The voltage clamping circuit 31 is not limited to being disposed on the chip or disposed outside the chip. It may be understood that, when the voltage clamping circuit 31 is disposed outside the chip, the voltage clamping circuit 31 may be connected through a PAD connected to the source s11. The voltage clamping circuit 31 may be a clamping diode (with a turn-on voltage V_{th_clamp}), so that when the Q11 to the Q1a are in a cut-off state, a high voltage between a drain d1 of the Q1 and the source s1a of the Q1a is mainly distributed at the drain d1 of the Q1 and a source s1 of the Q1, and there is basically no voltage division for the Q2 to the Q1a. In this way, Vg1i-s1i is at a relatively low negative voltage (several volts negative to 0 V), and it is ensured that gates of the Q11 to the Q1a are not negatively broken down. In addition, auxiliary units may also use the series connection solution shown in FIG. 17E. With reference to FIG. 23B, based on the chip in FIG. 17E, a voltage clamping circuit 31 is disposed between an equivalent source s1a of a 1^{st} auxiliary unit and an equivalent source sna of an n^{th} auxiliary unit. Moreover, voltage clamping circuits 31 (31-11, ..., and 31-1a) may also be disposed between a gate g1i and a source s1i of each HEMT in a Q11 to a Q1a (as shown in FIG. 23C), or voltage clamping circuits 31 (31-1, ..., and 31-n) are disposed between an equivalent gate gi1 and an equivalent source sia of an auxiliary unit (as shown in FIG. 23D). Furthermore, the voltage clamping circuit 31 includes but is not limited to one or more diodes, capacitors, and switching transistors that are connected in parallel or in series.

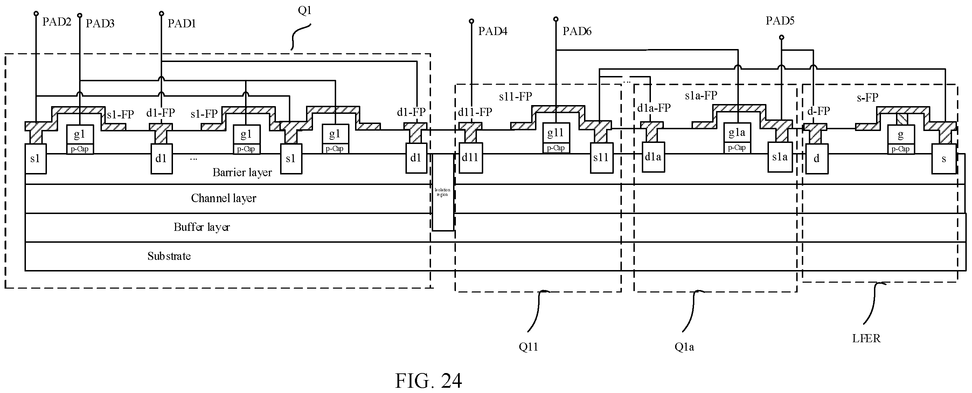

Further, in Example 3, FIG. 24 is a diagram of a cross-sectional structure of the chip shown in FIG. 23A. Cell structures of a Q1 and a Q11 to a Q1a still use an enhanced-mode HEMT that uses p-Cap as a gate semiconductor, and the Q11 to the Q1a are connected in series to form switching transistors on a current sampling link. In addition, a voltage clamping circuit 31 is disposed on an epitaxial layer of a same substrate. With reference to FIG. 24, an example in which the voltage clamping circuit 31 uses single-stage or multi-stage rectifier LFERs (lateral field-effect rectifiers) connected in series is used. To be specific, a gate g and a source s of a p-Cap HEMT are interconnected as an anode (Anode), and a drain d serves as a cathode (Cathode), which has a clamping characteristic similar to that of a diode, and a clamping voltage of a single LFER is denoted as V_{th_clamp}. If a single-stage LFER is used, an anode (Anode) of the LFER may be interconnected with a source s11 of the Q11, and a cathode (Cathode) the LFER is interconnected with a source s1a of the Q1a, when the Q1 is turned off, a potential voltage drop between the source s11 of the Q11 and the source s1a of the Q1a is limited to V_{th_clamp}. In this case, a voltage between a gate and a source of each HEMT Q1i is not less than -V_{th_clamp}. Alternatively, if multi-stage (which is denoted as x) LFERs connected in series are used, at least an anode of a first-stage LFER in the series connection structure is still interconnected with a source s11 of the Q11, and a cathode (Cathode) of a last-stage LFER is interconnected with a source s1a of the Q1a, when the Q1 is turned off, a potential voltage drop between the source s11 of the Q11 and the source s1a of the Q1a is limited to x*V_{th_clamp}. In this case, a voltage between a gate and a source of each HEMT Q1i is not lower than -x*V_{th_clamp} (to ensure that the gate satisfying x*V_{th_clamp}≤Q1i can withstand a negative voltage for a long period of time). In addition to the LFER, the voltage clamping circuit may also use any clamping structure such as a capacitor or a diode, and may be integrated with the chip, or may be separately connected a PAD on the chip. In addition, in some examples, a ratio of a gate width of the Q1 to a gate width of the LFER preferably ranges from 10:1 to 10000: 1.

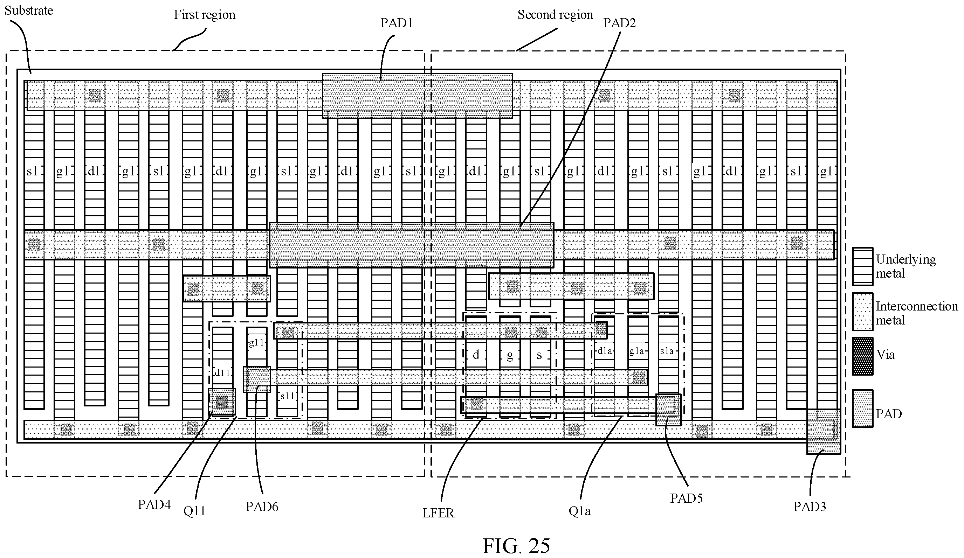

FIG. 25 shows a top view of the chip provided in Example 3. Based on the series connection solution in Embodiment 1 in the present invention, a voltage clamping circuit (for example, the LFER as shown in FIG. 25) is disposed on a same substrate material (including a GaN epitaxial layer). A gate g and a source s of the LFER are interconnected through interconnection metal to form an anode, and interconnected with a source s11 of a Q11. A drain d of the LFER is interconnected as a cathode C with a source s12 of a Qna through interconnection metal.

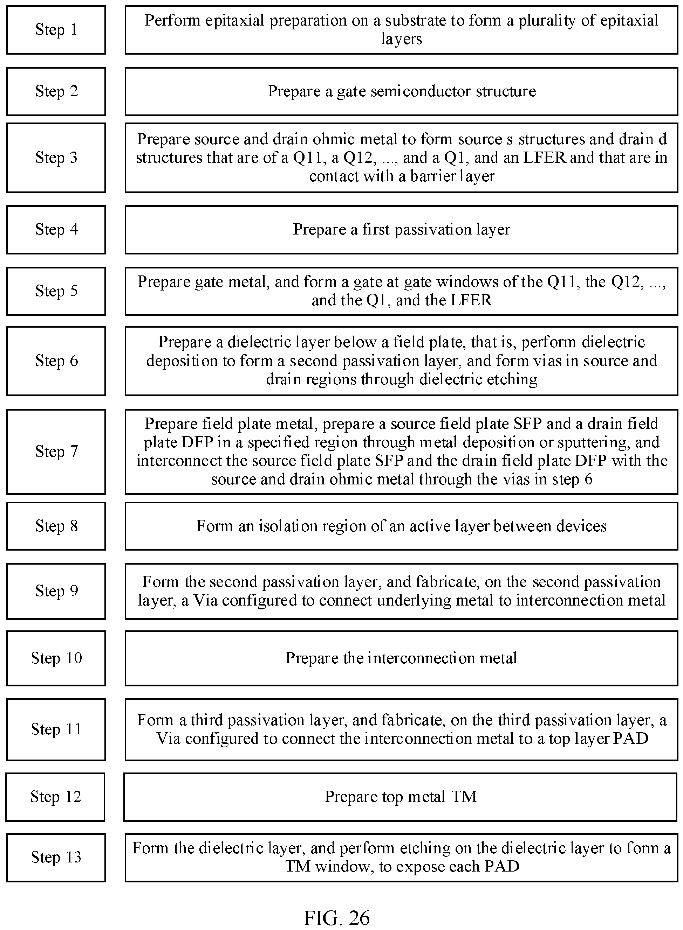

In Example 3, a method for fabricating the chip 30 (FIG. 25 is used as an example) is further provided. With reference to FIG. 26, the method includes the following steps.

Step 1: Perform epitaxial preparation on a substrate to form a plurality of epitaxial layers.

Step 2: Prepare a gate semiconductor structure.

Step 3: Prepare source and drain ohmic metal to form source s structures and drain d structures that are of a Q11, a Q12, ..., and a Q1, and an LFER and that are in contact with a barrier layer.

For example, the source and drain ohmic metal may be formed through a patterning process (including steps such as film formation and photolithography). First, source and drain metal layers are formed through metal deposition or sputtering; and then the source s structures and the drain d structures that are of the Q11, the Q12, ..., and the Q1, and the LFER and that are in contact with the barrier layer are formed through photolithography, and ohmic contact is formed through an annealing process.

Step 4: Prepare a first passivation layer.

The first passivation layer is formed through dielectric deposition at an AlGaN barrier layer and on a p-Cap surface, and may be any insulation dielectric such as aluminum nitride, silicon nitride, or silicon oxide. In addition, a source window, a drain window, and a gate window are formed through dielectric etching in source, drain, and gate regions.

Step 5: Prepare gate metal, and form a gate at gate windows of the Q11, the Q12, ..., and the Q1, and the LFER.

Step 6: Prepare a dielectric layer below a field plate, that is, perform dielectric deposition to form a second passivation layer, and form vias in the source and drain regions through dielectric etching.

Step 7: Prepare field plate metal, prepare a source field plate SFP and a drain field plate DFP in a specified region through metal deposition or sputtering, and interconnect the source field plate SFP and the drain field plate DFP with the source and drain ohmic metal through the vias in step 6.

This step is performed in source field plates SFPs and drain field plates DFPs of the Q11, the Q12, ..., and the Q1 and the LFER. The field source plate SFP and the drain field plate DFP of the LFER serve as an anode and a cathode thereof respectively.

Step 8: Form an isolation region of an active layer between devices.

Step 9: Form the second passivation layer, and fabricate, on the second passivation layer, a Via configured to connect underlying metal to interconnection metal.

On a surface of the device formed in step 8, the second passivation layer is formed through dielectric deposition, and may be any insulation dielectric such as aluminum nitride, silicon nitride, or silicon oxide. Then, a via is etched through one patterning process at a location at which the interconnection metal is fabricated, and metal is deposited in the via to form a Via.

Step 10: Prepare the interconnection metal.

Step 11: Form a third passivation layer, and fabricate, on the third passivation layer, a Via configured to connect the interconnection metal to a top layer PAD.

Step 12: Prepare top metal (top metal, TM).

Step 13: Form the dielectric layer, and perform etching on the dielectric layer to form a TM window, to expose each PAD.

Different from step 1 to step 13 in Example 1, in step 1 to step 13 in Example 3, a process of preparing the LFER is mainly illustrated. Materials and procedures of other parts are the same as those in Example 1. For details, refer to the specific description in Example 1.

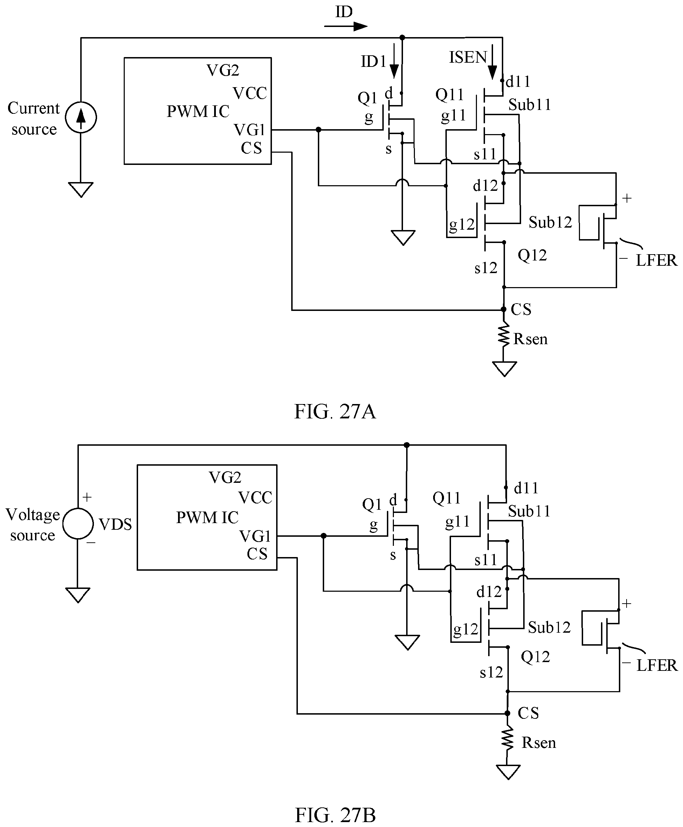

For verifying technical effects of Example 3, the simulation circuit diagram shown in FIG. 27A is used to simulate, by using a current source, sampled currents of the chip shown in FIG. 23A at different temperatures, and the simulation circuit shown in FIG. 27B is used to simulate, by using a voltage source, gate and source voltages when a voltage clamping circuit (an LFER) is present or not. With reference to FIG. 27A, an example in which a Q11 and a Q12 are connected in series on a current sampling link is used. A Q1, the Q11, and the Q12 are in a turn-on state. To be specific, a voltage 6 V is output by a PWM_IC to gates of the Q1, the Q11, and the Q12, a signal source is a current source, an output current is an ID (a current at an overcurrent detection point is set to Ids_on=5A), and a resistor Rsen still uses 2 ohm. The Q1 has a gate width WGmain and an impedance Rdson≈120mohm@25°C&Vgs=6V, both the Q11 and the Q12 have a gate width WGmain/100 and an impedance Rdson≈12 ohm@25°C&Vgs=6V, and the LFER may have a gate width WGmain/100 which is the same as that of the Q11 and the Q12. With reference to FIG. 27B, a Q1, a Q11, and a Q12 are in a cut-off state. To be specific, voltages output by a PWM_IC to the Q1, the Q11, and the Q12 are all set to a low level 0 V, and a signal source is a voltage source (VDS is set to Vds_off=600V).

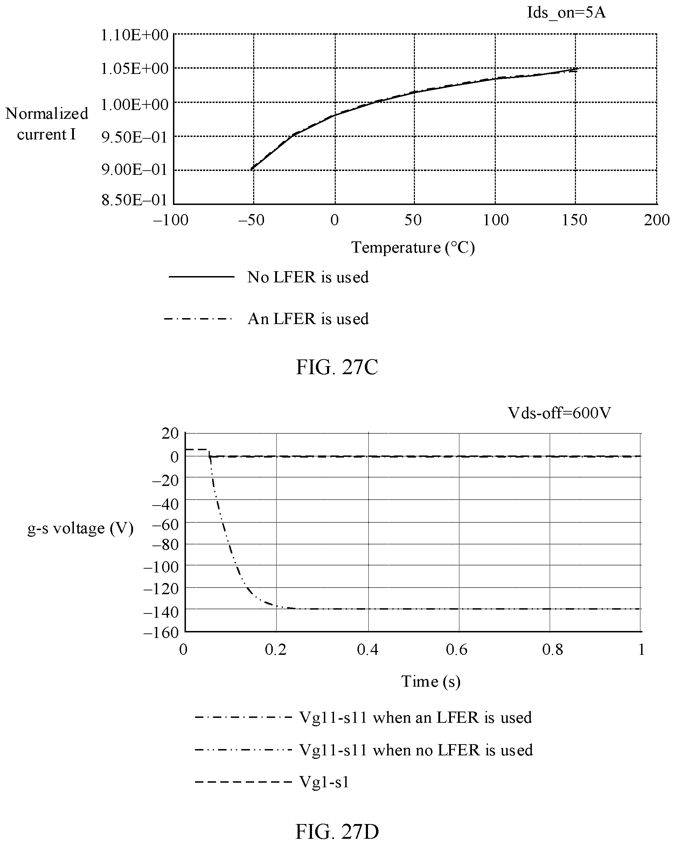

FIG. 27C shows simulation results of sampled currents at different temperatures. The simulation results are simulation results of detected currents at different temperatures when the LFER is used and when the LFER is not used. It can be seen that, during turn-on, a sampled current ISEN basically flows through only the Q11 and the Q12 because an impedance of the LFER >> impedances of the Q11 and the Q12. Therefore, when there is an LFER, impact on current detection precision can be basically ignored. FIG. 27D shows a case in which a gate-source voltage Vg11-s11 of the Q11 changes with a gate-source voltage Vg1-s1 of the Q1 when two ends of a device bear a high-voltage turn-off stress, an LFER is used, and no LFER is used. It can be learned that, after the gate-source voltage V_{G1-S1} of the Q1 decreases from a high voltage 6 V to a low-level voltage 0 V, two ends of the Q1 bear a high voltage Vds_off=600V. In this case, if there is no LFER, because the multi-stage HEMTs on the current sampling link use a series connection structure, as a device turn-off time increases and a source-drain capacitor Cds is charged gradually for other HEMTs except the Q1, a voltage drop at both ends of the source and drain also increases gradually, that is, the other HEMTs have a voltage division function (denoted as Vss). In this case, because Vg1-s1=Vg11-s1=0V, Vg11-g11≈0V-Vss. When the voltage is stable, Vg11-g11 may reach -xxx V, which easily causes negative breakdown of a gate of a device. If there is a clamping transistor, a high voltage is basically borne by the Q11, and no voltage division basically exists on the other HEMT devices, so that Vg11-s11 is maintained at a relatively low negative voltage value when the voltage is stable. Therefore, with reference to the voltage clamping circuit and the series connection HEMT solution, a problem such as HEMT gate-source breakdown caused by HEMT voltage division on the current sampling link can be suppressed while current sampling precision of a device is ensured.

### Example 4:

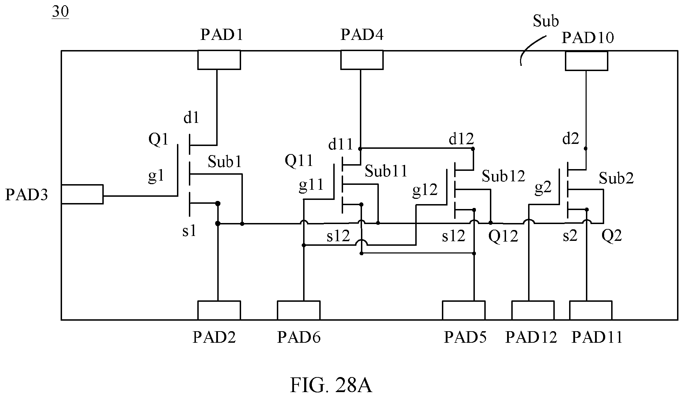

In Example 4, for example, for improving an integration level of the chip 30, the switching transistor Q2 used for high-voltage startup in FIG. 4 may alternatively be fabricated in the chip 30 provided in Example 1, Example 2, and Example 3. As shown in FIG. 28A, the chip 30 is provided, including a Q1 used for a power current link, and a Q11 and a Q12 used for a current sampling link. For a connection relationship thereof, refer to the descriptions of Example 1 to Example 3 above. In Example 4, as shown in FIG. 28A, a switching transistor Q2 used for high-voltage startup is further included. The Q2 may be a depletion-mode HEMT. A gate g2 of the Q2 may be connected to a PAD 12 and led out, and is connected to a PWM_IC (for example, which may be a VG2 of the PWM_IC). A drain d2 of the Q2 may be connected to a PAD10 and led out, and is connected to a high-potential end, for example, a dotted terminal p1 of a primary-side coil of a switching power supply. A source s2 of the Q2 may be connected to a PAD11 and led out, and is connected to the PWM_IC, for example, a VCC of the PWM_IC. The dotted terminal p1 of the primary-side coil is configured to supply power to the PWM_IC through the Q2, and the PWM_IC is further configured to control the Q2 to be cut off, namely, a high-voltage startup function. Details are not described in Example 4.

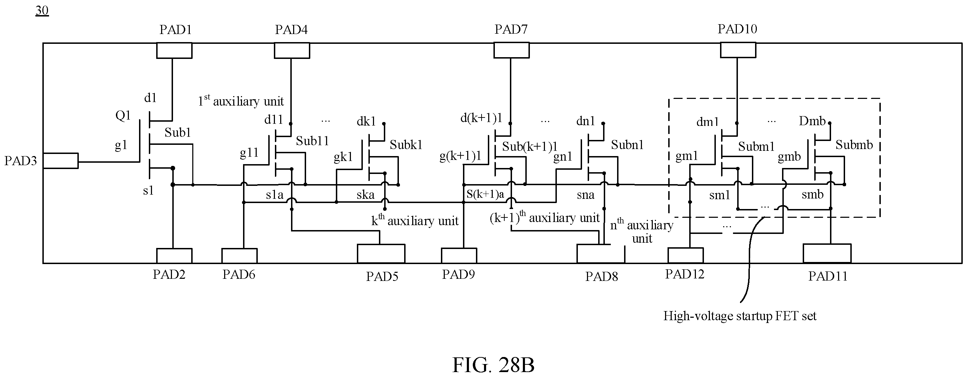

In addition, in some examples, for integrating the high-voltage startup function on the chip, more switching transistors connected in parallel to the switching transistor Q2 may be further disposed. For example, with reference to the chip shown in FIG. 28B, a high-voltage startup FET set (including at least b HVSU (high-voltage startup) HEMTs, where b≥1) is disposed, gates (a gm1 to a gmb) of the b HVSU HEMTs are electrically interconnected, and substrates (a Subm1 to a Submb) are electrically interconnected with a substrate Sub1 of the Q1. Although the HVSU HEMTs in the high-voltage startup FET set shown in FIG. 28B are connected in parallel, it may be understood that in some solutions, a connection manner similar to that of the HEMTs on the current sampling link may also be used, that is, a series connection manner or a manner of combining series and parallel connections is used. In addition, in some examples, a ratio of a gate width of the Q1 to a gate width of the HVSU HEMT preferably ranges from 10:1 to 10000: 1.

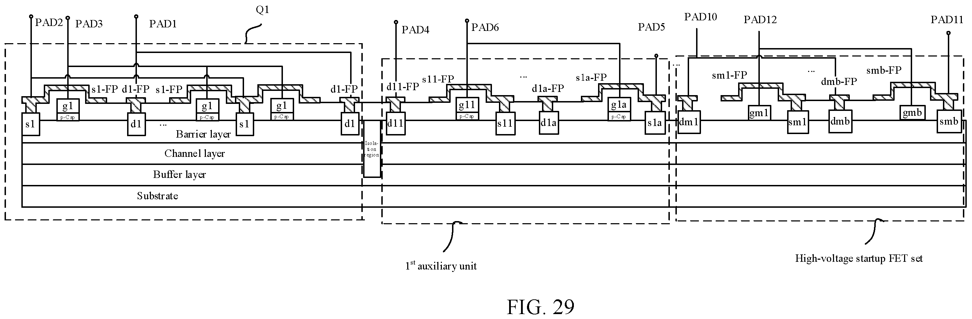

FIG. 29 is a diagram of a cross-sectional structure of a chip provided in Embodiment 4. Cell structures of a Q1 and a 1^{st} auxiliary unit still use an enhanced-mode HEMT structure that uses p-Cap as a gate semiconductor layer. On an epitaxial layer of a same substrate, a high-voltage startup FET set including b HVSU HEMTs is further disposed, and the HVSU HEMT may be of a depletion-mode HEMT structure.

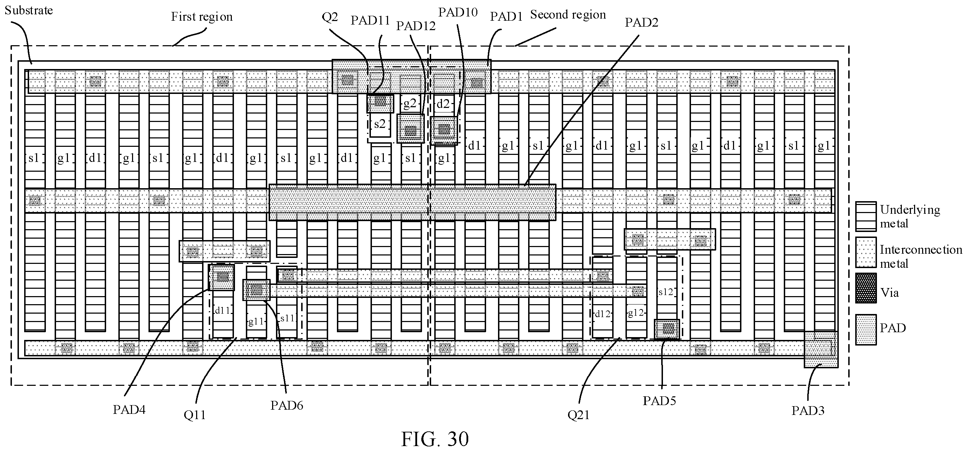

FIG. 30 is a diagram of a top-view structure of a chip provided in Example 4. HEMTs on a current sampling link include a Q11 and a Q12 that are connected in series. For a specific structure description, refer to the examples above. Details are not described herein again. In addition, it should be noted that a high-voltage startup FET set including a Q2 may also be used. PADs (a PAD 11 and a PAD 12) may be separately led out from a source s2 and a gate g2 of the Q2 to connect to a PWM_IC, and a PAD10 may be led out from a drain d2 to connect to a primary side.

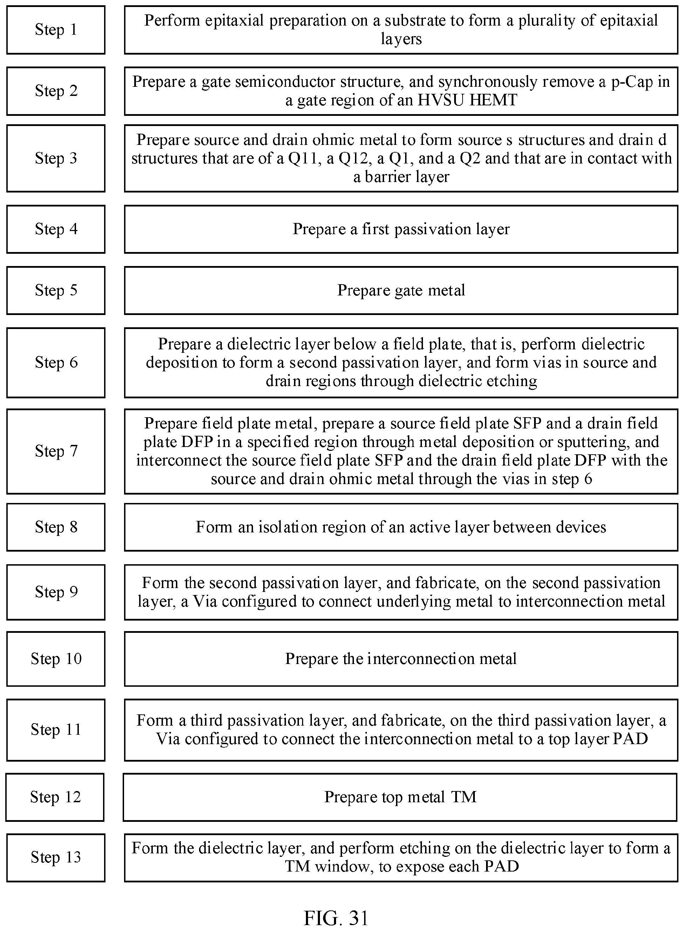

In Example 4, a method for fabricating the chip 30 is further provided. With reference to FIG. 31, the method includes the following steps.

Step 1: Perform epitaxial preparation on a substrate to form a plurality of epitaxial layers.

Step 2: Prepare a gate semiconductor structure, and synchronously remove a p-Cap in a gate region of an HVSU HEMT.

The gate semiconductor structure, namely, the p-Cap in FIG. 12A, is formed by removing a p-Cap material layer outside gate regions of a Q1, a Q11, a Q12, ..., and others through an etching process; and the p-Cap in a gate region of a Q2 is removed.

Step 3: Prepare source and drain ohmic metal to form source s structures and drain d structures that are of the Q11, the Q12, the Q1, and the Q2 and that are in contact with a barrier layer.

For example, the source and drain ohmic metal may be formed through a patterning process (including steps such as film formation and photolithography). First, source and drain metal layers are formed through metal deposition or sputtering; and then the source s structures and the drain d structures that are of the Q11, Q12, the Q1, and the Q2 and that are in contact with the barrier layer are formed through photolithography, and ohmic contact is formed through an annealing process.

Step 4: Prepare a first passivation layer.

The first passivation layer is formed through dielectric deposition at an AlGaN barrier layer and on a p-Cap surface, and may be any insulation dielectric such as aluminum nitride, silicon nitride, or silicon oxide. In addition, a source window, a drain window, and a gate window are formed through dielectric etching in source, drain, and gate regions.

Step 5: Prepare gate metal.

In this step, gates are formed at gate windows of the Q11, the Q12, the Q1, and the Q2.

Step 6: Prepare a dielectric layer below a field plate, that is, perform dielectric deposition to form a second passivation layer, and form vias in the source and drain regions through dielectric etching.

Step 7: Prepare field plate metal, prepare a source field plate SFP and a drain field plate DFP in a specified region through metal deposition or sputtering, and interconnect the source field plate SFP and the drain field plate DFP with the source and drain ohmic metal through the vias in step 6.

This step is performed on source field plates SFPs and drain field plates DFPs of the Q11, the Q12, the Q1, and the Q2.

Step 8: Form an isolation region of an active layer between devices.

Step 9: Form the second passivation layer, and fabricate, on the second passivation layer, a Via configured to connect underlying metal to interconnection metal.

Step 10: Prepare the interconnection metal.

Step 11: Form a third passivation layer, and fabricate, on the third passivation layer, a Via configured to connect the interconnection metal to a top layer PAD.

Step 12: Prepare top metal (top metal, TM).

Step 13: Form the dielectric layer, and perform etching on the dielectric layer to form a TM window, to expose each PAD.

Different from step 1 to step 13 in Example 1, in step 1 to step 13 in Example 4, a process of preparing the Q2 is mainly illustrated. Materials and procedures of other parts are the same as those in Example 1. For details, refer to the specific description in Example 1.

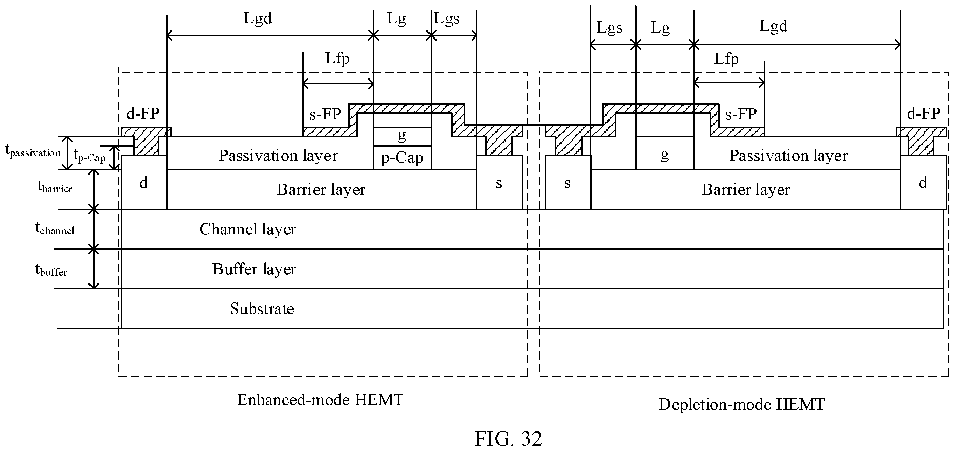

For verifying technical effects of Example 4, currents and voltages of an integrated enhanced-mode HEMT and a depletion-mode HEMT are simulated to verify whether the depletion-mode HEMT device can work normally in a p-Cap HEMT process. FIG. 32 shows a simulation structure, including an enhanced-mode (Emode) HEMT and a depletion-mode (Dmode) HEMT. An epitaxial structure of the HEMT includes: a buffer (Buffer) layer with a thickness of t_{buffer}=4um, a channel (Channel) layer with a thickness of t_{channel}=100nm, a barrier layer AlGaN Barrier with a thickness of t_{barrier}=15nm and an Al component x=18%, and a gate semiconductor p-GaN layer with a thickness of t_{p-Cap}=90nm, and a passivation (Passivation) layer with a thickness of tₚₐₛₛᵢᵥₐₜᵢₒₙ=300nm that are all disposed above a Si substrate. In addition, a same gate-source spacing Lgs=1.5 um, a gate length Lg=1.5 um, a source field plate S-FP length Lfp=3 um, and a gate-drain spacing Lgd=15 um specified disposed in Emode and Dmode structures.

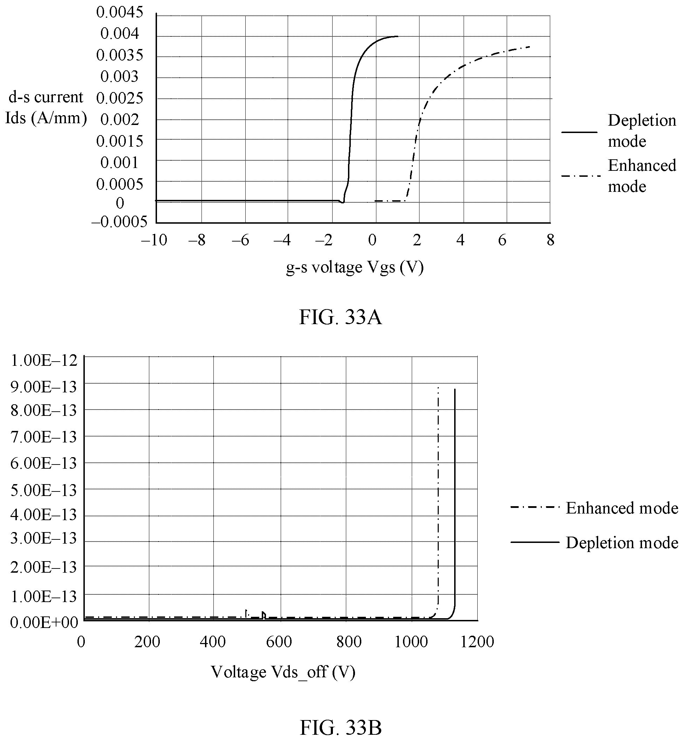

FIG. 33A and FIG. 33B show simulation results. FIG. 33A is a transition curve diagram of an Emode structure and a Dmode structure. When a conventional characteristic (a threshold voltage is about 1.5 V) of an Emode device is maintained, a Dmode device prepared through an integrating process has a steady turn-on characteristic (the threshold voltage is about -1.5 V, and may be adjusted from -1.5 V to -xx V via a gate medium), and a turn-on impedance of the Emode device at a gate voltage of 6 V is basically the same as that of the Dmode device at a gate voltage of 0 V. This indicates that, in this integration solution, both the enhanced-mode HEMT and the depletion-mode HEMT can be normally turned on. FIG. 33B is a breakdown characteristic diagram of an Emode structure and a Dmode structure. During turn-off, a gate voltage of the Emode device is set to 0 V, and a gate voltage of the Dmode device is set to -3 V. With a same cell size and a same field plate structure, breakdown characteristics of an enhanced-mode HEMT and a depletion-mode HEMT are basically the same. This indicates that, in this solution, both the enhanced-mode structure and the depletion-mode structure can be normally turned off.

In Example 4, it is considered that an HEMT with a high-voltage startup function is integrated into a chip with a GaN process. In addition, because the HEMT with the high-voltage startup function has a high risk of performance (Ron, Vth) deterioration after working for a long time under stress, a plurality of HEMTs may be cascaded to form a high-voltage startup FET set. This can improve deterioration of key parameters (such as Rdson and Vth) of the HEMT with the high-voltage startup function due to a process and material defect fluctuation. Moreover, this can reduce high-voltage and small-current stress borne by each HEMT device through shunting or voltage division, to further suppress performance deterioration of the device, improve overall consistency of HEMT parameters of the high-voltage startup function, and ensure precision of controlling a high-voltage startup voltage. In addition, in Example 4 of this application, when the HEMT on the current sampling link is integrated into the chip, the HEMT with the high-voltage startup function is also integrated into the chip. This further simplifies packaging complexity of a co-packaged device (a control chip), simplifies a packaging layout, and improves packaging reliability.

### Example 5:

A diagram of a structure of a control chip 40 is provided. In this example, a PWM_IC and the chip 30 provided in Example 1 to Example 4 above may be packaged into a co-packaged device to form the control chip 40, which may be used in a scenario such as a fast charging adapter or a high-voltage inverter. Compared with the co-packaged device provided in FIG. 5 or FIG. 7, the co-packaged device in the solution in Example 5 has a higher integration level and a simpler package structure. In addition, the structure is optimized (the solution provided in Example 1 to Example 4 above) to further improve performance fluctuation of an HEMT (an HEMT with a current sampling or high-voltage startup function) due to a process, and obtain better current sampling detection precision and high-voltage startup voltage control precision.

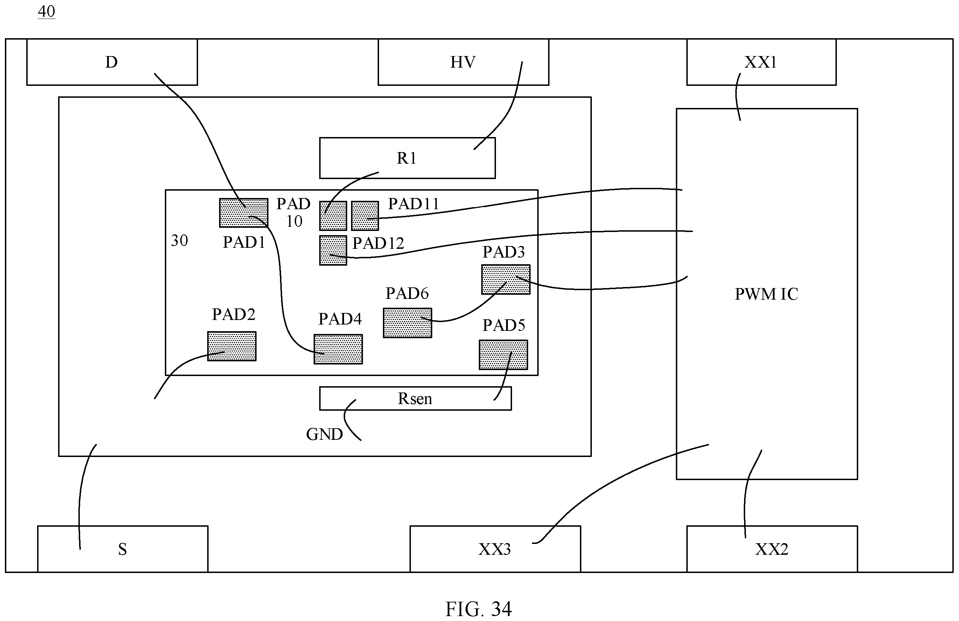

An implementation solution of a co-packaged device that uses the structure of the chip in FIG. 30 is shown in FIG. 34, which is a diagram of a square flat non-leads package (quad flat no-leads package, QFN) structure. The co-packaged device 40 includes the PWM_IC and the chip 30, and may further include a sampling resistor Rsen (the Rsen may also be externally connected, or integrated into the chip 30, or integrated into the PWM_IC). Electrodes of the QFN co-packaged device include a drain D (configured to connect to an undotted terminal p2 of a primary side of a transformer), an HV (high voltage) electrode (configured to connect a dotted terminal p1 of the primary side of the transformer, where the resistor R1 shown in FIG. 7 may also be integrated in the package structure), a source S, and electrodes for controlling the PWM_IC and providing electrical signals (shown by XX (XX1, XX2, and XX3)). APAD1 connected to a drain d1 of a Q1 of the chip 30 is interconnected with D through wire bonding (Wire bonding, wire bonding), a PAD2 connected to a source s1 of the Q1 is interconnected with a QFN-packaged metal frame (lead frame) and S and GND through wire bonding, and a PAD3 connected to a gate g1 of the Q1 is interconnected with the PWM_IC (for example, connected to a VG1 of the PWM) through wire bonding. A PAD5 connected to a source s12 of a Q12 forming a current sampling link of the chip 30 may be interconnected with a first end of a sampling resistor Rsen and a CS of the PWM_IC through wire bonding, and the other end of the sampling resistor Rsen is connected to GND or S. A PAD4 connected to a drain d11 of a Q11 forming the current sampling link of the chip 30 may be interconnected with the PAD1 connected to the gate g1 of the Q1 through wire punching. A PAD6 connected to a gate g11 of the Q11 and a gate g12 of a Q12 may be interconnected with the gate g1 of the Q1. A PAD10 connected to a drain d2 of a Q2 with a high-voltage startup function in the chip 30 is interconnected with the HV electrode through wire bonding (certainly, as shown in FIG. 24, the resistor R1 in FIG. 7 may also be integrated into a co-packaged device; and in this case, the PAD10 is connected to one end of the R1 through wire bonding, and the other end of the R1 is connected to the HV electrode through wire bonding). A PAD12 connected to a gate g2 of the Q2 and a PAD11 connected to a source s2 of the Q2 are connected to the PWM_IC through wire bonding (for example, the PAD12 is connected to a VG2 of the PWM_IC, and the PAD11 is connected to a VCC of the PWM_IC). The entire co-packaged device uses the QFN, which can greatly balance a packaging thermal resistance, ease of mounting, and cost optimization. Certainly, this embodiment of this application is not limited to the QFN, and the chip 30 and the PWM_IC may also be packaged in another form.

### Example 6:

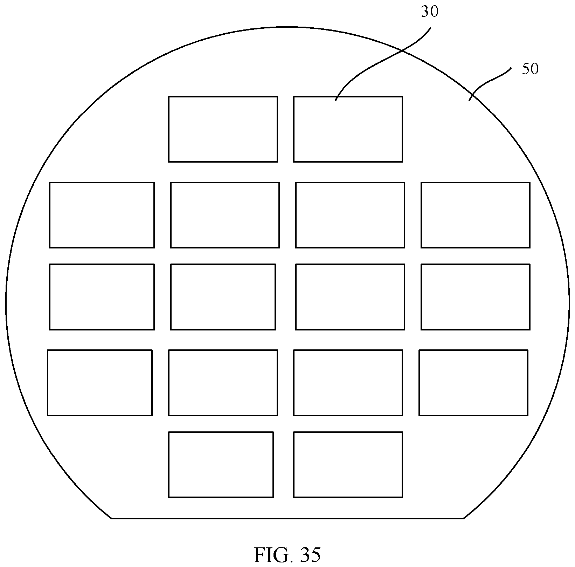

As shown in FIG. 35, a wafer 50 is provided, including any one of the chips 30 that are distributed in an array and that are shown in Example 1 to Example 4 above.

Although this application is described with reference to embodiments, in a process of implementing this application that claims protection, a person skilled in the art may understand and implement another variation of the disclosed embodiments by viewing the accompanying drawings, disclosed content, and the appended claims. In the claims, "comprising" does not exclude another component or another step, and "a" or "one" does not exclude a meaning of plurality. Some measures are recorded in dependent claims that are different from each other, but this does not mean that these measures cannot be combined to produce a better effect.

The foregoing has described embodiments of this application. The foregoing descriptions are examples, not exhaustive, and are not limited to the disclosed embodiments. Many modifications and changes are apparent to a person of ordinary skill in the art without departing from the scope and spirit of the described embodiments. The selection of terms used in the specification is intended to best explain the principles of embodiments, practical applications, or improvements to technologies in the market, or to enable another person of ordinary skill in the art to understand embodiments disclosed in the specification.

## Claims

1. A chip, comprising:
a substrate;
a first switching transistor fabricated on the substrate, wherein a drain of the first switching transistor is connected to a first pad, a source of the first switching transistor is connected to a second pad, and a gate of the first switching transistor is connected to a third pad, wherein
the first pad is configured to connect to a high-potential end, the second pad is configured to connect to a low-potential end, and the third pad is configured to connect to a control integrated circuit; and
a second switching transistor and a third switching transistor that are fabricated on the substrate, wherein the second switching transistor is disposed in a first region on the substrate, and the third switching transistor is disposed in a second region on the substrate, wherein
a drain of the second switching transistor and a drain of the third switching transistor are connected to a fourth pad, and a source of the second switching transistor and a source of the third switching transistor are connected to a fifth pad; or the drain of the second switching transistor is connected to the fourth pad, the drain of the third switching transistor is connected to the source of the second switching transistor, and the source of the third switching transistor is connected to the fifth pad;
a gate of the second switching transistor and a gate of the third switching transistor are connected to a sixth pad; and
the fourth pad is configured to connect to the high-potential end, the fifth pad is configured to connect to a sampling circuit, and the sixth pad is configured to connect to the control integrated circuit.

2. The chip according to claim 1, wherein the substrate comprises a first equal partition region and a second equal partition region, the first region is the first equal partition region, and the second region is the second equal partition region.

3. The chip according to claim 1 or 2, wherein a ratio of an average impedance of the second switching transistor and the third switching transistor to an impedance of the first switching transistor ranges from 10:1 to 1000: 1.

4. The chip according to any one of claims 1 to 3, wherein the first switching transistor, the second switching transistor, and the third switching transistor have a consistent cell structure, and the second switching transistor and the third switching transistor occupy a same area on the substrate.

5. The chip according to any one of claims 1 to 4, further comprising a fourth switching transistor, wherein the fourth switching transistor is disposed in a third region on the substrate, a drain of the fourth switching transistor is connected to a seventh pad, a source of the fourth switching transistor is connected to an eighth pad, and a gate of the fourth switching transistor is connected to a ninth pad;
the seventh pad is configured to connect to the high-potential end;
the eighth pad is configured to connect to the sampling circuit, or the eighth pad is configured to connect to the low-potential end; and
the ninth pad is configured to connect to the control integrated circuit.

6. The chip according to any one of claims 1 to 4, further comprising a fourth switching transistor, wherein the fourth switching transistor is disposed in a third region on the substrate, a drain of the fourth switching transistor is connected to a seventh pad, a source of the fourth switching transistor is connected to an eighth pad, and a gate of the fourth switching transistor is connected to a ninth pad;
the fifth pad is configured to connect to the seventh pad;
the eighth pad is configured to connect to the sampling circuit; and
the ninth pad is configured to connect to the control integrated circuit.

7. The chip according to claim 5 or 6, wherein the substrate further comprises a third equal partition region, and the third region is the third equal partition region.

8. The chip according to any one of claims 1 to 7, wherein the fourth pad and the first pad share a same pad.

9. The chip according to any one of claims 1 to 7, wherein the third pad and the sixth pad share a same pad.

10. The chip according to claim 5, wherein the seventh pad and the first pad share a same pad.

11. The chip according to claim 5 or 6, wherein the third pad and the ninth pad share a same pad.

12. The chip according to any one of claims 1 to 11, further comprising a fifth switching transistor, wherein
a drain of the fifth switching transistor is connected to a tenth pad, a source of the fifth switching transistor is connected to an eleventh pad, and a gate of the fifth switching transistor is connected to a twelfth pad;
the tenth pad is configured to connect to the high-potential end;
the eleventh pad is configured to connect to the control integrated circuit;
the twelfth pad is configured to connect to the control integrated circuit; and
the high-potential end is configured to supply power to the control integrated circuit through the fifth switching transistor, and the control integrated circuit is further configured to control the fifth switching transistor to be cut off.

13. The chip according to claim 12, further comprising a sixth switching transistor, wherein
a drain of the sixth switching transistor is connected to the tenth pad, a source of the sixth switching transistor is connected to the eleventh pad, and a gate of the sixth switching transistor is connected to the twelfth pad; and
the high-potential end is configured to supply power to the control integrated circuit through the sixth switching transistor, and the control integrated circuit is further configured to control the sixth switching transistor to be cut off.

14. The chip according to any one of claims 1 to 13, wherein the source of the second switching transistor is connected to a thirteenth pad, and the thirteenth pad is configured to connect to a voltage clamping circuit.

15. The chip according to any one of claims 1 to 14, further comprising the voltage clamping circuit, wherein the voltage clamping circuit is fabricated on the substrate, and the voltage clamping circuit is connected to the source of the second switching transistor; or the voltage clamping circuit is connected between the source and the gate of the second switching transistor.

16. The chip according to claim 14 or 15, wherein the voltage clamping circuit comprises a capacitor or a diode, wherein an anode of the diode is connected to the source of the second switching transistor.

17. The chip according to any one of claims 1 to 16, wherein a ratio of a gate width of the first switching transistor to a gate width of the second switching transistor ranges from 10:1 to 10000: 1, and a ratio of the gate width of the first switching transistor to a gate width of the third switching transistor ranges from 10:1 to 10000:1.

18. The chip according to claim 12, wherein a ratio of a gate width of the first switching transistor to a gate width of the fifth switching transistor ranges from 10:1 to 10000: 1.

19. The chip according to claim 16, wherein the diode comprises an eighth switching transistor, a source and a gate of the eighth switching transistor are connected to the anode of the diode, and a drain of the eighth switching transistor is connected to a cathode of the diode; and
a ratio of a gate width of the first switching transistor to a gate width of the eighth switching transistor ranges from 10:1 to 10000: 1.

20. The chip according to any one of claims 1 to 19, wherein each switching transistor is a high-electron-mobility transistor.

21. A control chip, wherein the control chip is used in a switching power supply, and comprises a package structure, the chip that is packaged in the package structure according to any one of claims 1 to 20, and a control integrated circuit.

22. The control chip according to claim 21, wherein the package structure further comprises a sampling circuit.

23. A switching power supply, comprising a transformer and the control chip according to claim 21 or 22, wherein
the transformer comprises a primary-side coil and a secondary-side coil, and the control chip is connected to the primary-side coil.

24. A power adapter, comprising a housing, and the switching power supply mounted inside the housing according to claim 23 or the control chip according to claim 21 or 22.

25. A charging system, comprising a power adapter and a terminal device, wherein the power adapter is connected to the terminal device, and the power adapter comprises the power adapter according to claim 24.

26. A wafer, comprising a plurality of chips that are distributed in an array according to any one of claims 1 to 20.
